# EUROPEAN PATENT SPECIFICATION

(11) **EP 3 891 808 B1**
(45) Date of publication and mention of the grant of the patent: **14.05.2025**
(21) Application number: 19927542.1
(22) Date of filing: 24.07.2019
(51) Int. Cl.: H01L 25/18, H01L 27/06, H01L 23/31, G11C 16/04, G11C 13/00, G11C 11/56, G11C 11/401, G11C 11/00, G06F 11/10, H01L 25/065, H01L 23/00, H01L 25/00, H10B 12/00, H10B 63/00, H10B 43/40, H10N 70/20, H10B 43/27

(54) **BONDED MEMORY DEVICES HAVING FLASH MEMORY CONTROLLER AND FABRICATION AND OPERATION METHODS THEREOF**
GEBONDETE SPEICHERVORRICHTUNGEN MIT FLASH-SPEICHER-STEUERGERÄT UND HERSTELLUNG UND BETRIEBSVERFAHREN DAFÜR
DISPOSITIFS DE MÉMOIRE BONDÉS PRÉSENTANT UN CONTRÔLEUR DE MÉMOIRE FLASH ET PROCÉDÉS DE FABRICATION ET DE FONCTIONNEMENT ASSOCIÉS

(30) Priority: 30.04.2019 WO PCT/CN2019/085237
(43) Date of publication of application: 13.10.2021
(60) Divisional application: 25169134.1
(73) Proprietor: Yangtze Memory Technologies Co., Ltd., Wuhan, Hubei 430000 (CN)
(72) Inventor: CHENG, Weihua, Wuhan, Hubei 430000 (CN); LIU, Jun, Wuhan, Hubei 430000 (CN)
(74) Representative: Lippert Stachow Patentanwälte Rechtsanwälte
(86) International application number: PCT/CN2019/097441
(87) International publication number: WO 2020/220483

(56) References cited:
- CN-A- 109 119 426
- CN-A- 109 256 392
- CN-A- 109 564 923
- US-A1- 2005 128 808
- US-A1- 2010 007 014
- US-A1- 2015 340 366
- US-A1- 2018 374 864
- US-A1- 2018 374 864
- US-A1- 2019 043 868
- US-A1- 2019 057 756

## Description

### CROSS-REFERENCE TO RELATED APPLICATIONS

This application claims the benefit of priority to International Application No. PCT/CN2019/085237, filed on April 30, 2019, entitled "THREE-DIMENSIONAL MEMORY DEVICE WITH EMBEDDED DYNAMIC RANDOM-ACCESS MEMORY,".

### BACKGROUND

Embodiments of the present disclosure relate to semiconductor devices and fabrication and operation methods thereof.

US2018/374864 A1 discloses a memory device, comprising:
a first semiconductor structure comprising a Flash memory controller, a peripheral circuit, and a first bonding layer comprising a plurality of first bonding contacts;
a second semiconductor structure comprising an array of NAND memory cells and a second bonding layer comprising a plurality of second bonding contacts;
wherein the peripheral circuit comprises one or more page buffers and word line drivers of the array of NAND memory cells, and wherein the Flash memory controller comprises a host interface operatively coupled to a host processor, a NAND memory interface operatively coupled to the array of NAND memory cells, a management module, and an error correction code module;
wherein the first semiconductor structure comprises a first interconnect layer vertically between the first bonding layer and the Flash memory controller, and the second semiconductor structure comprises a second interconnect layer vertically between the second bonding layer and the array of NAND memory cells;
and a bonding interface between the first bonding layer and the second bonding layer, wherein the first bonding contacts are in contact with the second bonding contacts at the bonding interface, and wherein the bonding interface between the first bonding layer and the second bonding layer is as a result of hybrid bonding that obtains metal-metal bonding and dielectric-dielectric bonding simultaneously;
wherein the peripheral circuit is electrically connected to the Flash memory controller through the first interconnect layer; and wherein the peripheral circuit is electrically connected to the array of NAND memory cells through the first and second interconnect layers and the first and second bonding contacts.

US2019/043868 A1 discloses three-dimensional (3D) memory with an array and control circuitry in separately processed and bonded wafers. In one example, a non-volatile storage component includes a first die including a three-dimensional (3D) array of non-volatile storage cells and a second die bonded with the first die. The second die includes CMOS (complementary metal oxide semiconductor) circuitry to access the 3D array of non-volatile storage cells.

US2019/057756 discloses structures and methods for testing three-dimensional (3D) memory devices. In one example, a 3D memory device includes a memory array structure, a peripheral device structure, and an interconnect layer in contact with a front side of the memory array structure and a front side of the peripheral device structure, and a conductive pad at a back side of the memory array structure and that overlaps the memory array structure. The memory array structure includes a memory array stack, a through array contact (TAC) extending vertically through at least part of the memory array stack, and a memory array contact. The peripheral device structure includes a test circuit. The interconnect layer includes an interconnect structure. The conductive pad, the TAC, the interconnect structure, and at least one of the test circuit and the memory array contact are electrically connected.

Flash memory controllers (also known as Flash controllers) manage the data stored in Flash memory and communicate with a computer and/or electronic device. Flash memory controllers can provide various control functions to prevent a heavier burden on the host processor. Currently, there are two types of Flash memory controllers available for Flash memory devices. The first option is a discrete Flash controller, which is an individual chip to communicate with the host processor and NAND Flash memory chip through system buses. The other option is an integrated Flash controller in the same package with the NAND Flash memory chip, which, however, still requires a separate Flash controller chip connected to the NAND Flash memory chip through wire bonding.

### SUMMARY

Embodiments of bonded memory devices having a Flash memory controller and fabrication and operation methods thereof are disclosed herein.

Embodiments in accordance with the claimed invention are defined in the appended claims.

In one example, a memory device includes a first semiconductor structure including a Flash memory controller, a peripheral circuit, and a first bonding layer including a plurality of first bonding contacts. The memory device also includes a second semiconductor structure including an array of NAND memory cells and a second bonding layer including a plurality of second bonding contacts. The memory device further includes a bonding interface between the first bonding layer and the second bonding layer. The first bonding contacts are in contact with the second bonding contacts at the bonding interface. Further features of the memory device are defined in Claim 1.

In another example, a method for forming the memory device is disclosed.

In still another example, a method for operating the memory device is disclosed.

### BRIEF DESCRIPTION OF THE DRAWINGS

The accompanying drawings, which are incorporated herein and form a part of the specification, illustrate embodiments of the present disclosure and, together with the description, further serve to explain the principles of the present disclosure and to enable a person skilled in the pertinent art to make and use the present disclosure.

FIGS. 1A, 1B, 9, 10, 11A, 11B and 12 illustrate embodiments in accordance with the claimed invention.

All other figures illustrate examples not falling within the scope of the claims but useful for the understanding thereof.
FIG. 1A illustrates a schematic view of a cross-section of an exemplary memory device, according to some embodiments.
FIG. 1B illustrates a schematic view of a cross-section of another exemplary memory device, according to some embodiments.
FIG. 2 illustrates a schematic plan view of an exemplary semiconductor structure having a Flash memory controller, according to some embodiments.
FIG. 3A illustrates a cross-section of an exemplary memory device having three-dimensional (3D) NAND memory interconnected onto a Flash memory controller, according to some embodiments.
FIG. 3B illustrates a cross-section of an exemplary memory device having two-dimensional (2D) NAND memory interconnected onto a Flash memory controller, according to some embodiments.
FIG. 4A illustrates a cross-section of another exemplary memory device having 3D NAND memory interconnected beneath a Flash memory controller, according to some embodiments.
FIG. 4B illustrates a cross-section of another exemplary memory device having 2D NAND memory interconnected beneath a Flash memory controller, according to some embodiments.
FIGs. 5A-5C illustrate a fabrication process for forming an exemplary semiconductor structure having a Flash memory controller, according to some embodiments.
FIGs. 6A and 6B illustrate a fabrication process for forming an exemplary semiconductor structure having 3D NAND memory strings, according to some embodiments.
FIGs. 6C and 6D illustrate a fabrication process for forming an exemplary semiconductor structure having 2D NAND memory cells, according to some embodiments.
FIGs. 7A and 7B illustrate a fabrication process for forming an exemplary memory device, according to some embodiments.
FIGs. 7C and 7D illustrate a fabrication process for forming another exemplary memory device, according to some embodiments.
FIG. 8 illustrates a schematic diagram of a discrete host processor, a Flash memory controller, and NAND memory on a printed circuit board (PCB) and operations thereof.
FIG. 9 illustrates a schematic diagram of an exemplary memory device having a Flash memory controller on a PCB and operations thereof, according to some embodiments.
FIG. 10 illustrates a detailed schematic diagram of one example of the Flash memory controller in FIG. 9, according to some embodiments.
FIG. 11A is a flowchart of an exemplary method for forming a memory device, according to some embodiments.
FIG. 11B is a flowchart of another exemplary method for forming a memory device, according to some embodiments.
FIG. 12 is a flowchart of an exemplary method for operating a memory device, according to some embodiments.

Embodiments of the present disclosure will be described with reference to the accompanying drawings.

### DETAILED DESCRIPTION

Although specific configurations and arrangements are discussed, it should be understood that this is done for illustrative purposes only.

It is noted that references in the specification to "one embodiment," "an embodiment," "an example embodiment," "some embodiments," *etc.,* indicate that the embodiment described may include a particular feature, structure, or characteristic, but every embodiment may not necessarily include the particular feature, structure, or characteristic. Moreover, such phrases do not necessarily refer to the same embodiment. Further, when a particular feature, structure or characteristic is described in connection with an embodiment, it would be within the knowledge of a person skilled in the pertinent art to affect such feature, structure or characteristic in connection with other embodiments whether or not explicitly described.

In general, terminology may be understood at least in part from usage in context. For example, the term "one or more" as used herein, depending at least in part upon context, may be used to describe any feature, structure, or characteristic in a singular sense or may be used to describe combinations of features, structures or characteristics in a plural sense. Similarly, terms, such as "a," "an," or "the," again, may be understood to convey a singular usage or to convey a plural usage, depending at least in part upon context. In addition, the term "based on" may be understood as not necessarily intended to convey an exclusive set of factors and may, instead, allow for existence of additional factors not necessarily expressly described, again, depending at least in part on context.

It should be readily understood that the meaning of "on," "above," and "over" in the present disclosure should be interpreted in the broadest manner such that "on" not only means "directly on" something but also includes the meaning of "on" something with an intermediate feature or a layer therebetween, and that "above" or "over" not only means the meaning of "above" or "over" something but can also include the meaning it is "above" or "over" something with no intermediate feature or layer therebetween (i.e., directly on something).

Further, spatially relative terms, such as "beneath," "below," "lower," "above," "upper," and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "substrate" refers to a material onto which subsequent material layers are added. The substrate itself can be patterned. Materials added on top of the substrate can be patterned or can remain unpatterned. Furthermore, the substrate can include a wide array of semiconductor materials, such as silicon, germanium, gallium arsenide, indium phosphide, *etc.* Alternatively, the substrate can be made from an electrically non-conductive material, such as a glass, a plastic, or a sapphire wafer.

As used herein, the term "layer" refers to a material portion including a region with a thickness. A layer can extend over the entirety of an underlying or overlying structure or may have an extent less than the extent of an underlying or overlying structure. Further, a layer can be a region of a homogeneous or inhomogeneous continuous structure that has a thickness less than the thickness of the continuous structure. For example, a layer can be located between any pair of horizontal planes between, or at, a top surface and a bottom surface of the continuous structure. A layer can extend horizontally, vertically, and/or along a tapered surface. A substrate can be a layer, can include one or more layers therein, and/or can have one or more layers thereupon, thereabove, and/or therebelow. A layer can include multiple layers. For example, an interconnect layer can include one or more conductor and contact layers (in which interconnect lines and/or via contacts are formed) and one or more dielectric layers.

As used herein, the term "nominal/nominally" refers to a desired, or target, value of a characteristic or parameter for a component or a process operation, set during the design phase of a product or a process, together with a range of values above and/or below the desired value. The range of values can be due to slight variations in manufacturing processes or tolerances. As used herein, the term "about" indicates the value of a given quantity that can vary based on a particular technology node associated with the subject semiconductor device. Based on the particular technology node, the term "about" can indicate a value of a given quantity that varies within, for example, 10-30% of the value (e.g., ±10%, ±20%, or ±30% of the value).

As used herein, the term "3D NAND memory string" refers to a vertically-oriented string of memory cell transistors connected in series on a laterally-oriented substrate so that the string of memory cell transistors extends in the vertical direction with respect to the substrate. As used herein, the term "vertical/vertically" means nominally perpendicular to the lateral surface of a substrate.

For existing NAND Flash memory, the Flash memory controller is either a discrete chip on the circuit board (e.g., PCB) or integrated into the same package with the NAND memory chip but still as a separate chip. However, the Flash controller on the PCB occupies additional PCB space and uses relatively slow data buses between the NAND memory chip and the host processor. As to the integrated Flash controller, additional cost is added to the device for adding the Flash controller chip, and extra space is required in the package. Moreover, data communication between the Flash controller chip and the NAND memory chip is also relatively slow through wire bonding.

Various embodiments in accordance with the present disclosure provide a memory device integrating a Flash memory controller and NAND memory into a single bonded chip, with improved bidirectional data processing and transfer throughput between the Flash memory controller and the NAND memory within the same chip, thereby achieving overall faster system speed, while reducing PCB footprint at the same time. In some embodiments, the peripheral circuit of the NAND memory is formed on the same substrate with the Flash memory controller. The NAND memory cell array (either 2D or 3D) can be formed on another substrate and then bonded to the substrate on which the Flash controller is formed.

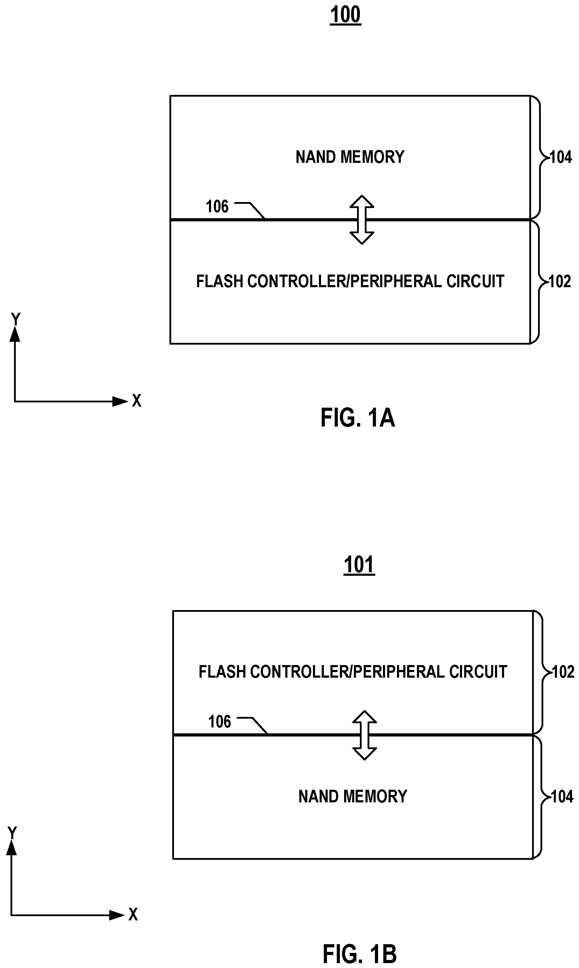

FIG. 1A illustrates a schematic view of a cross-section of an exemplary memory device 100, according to some embodiments. Memory device 100 represents an example of a bonded chip. The components of memory device 100 (e.g., Flash memory controller/peripheral circuit and NAND memory) are formed separately on different substrates and then joined to form a bonded chip. Memory device 100 includes a first semiconductor structure 102 having a Flash memory controller and a peripheral circuit of the NAND memory. In some embodiments, the Flash memory controller and the peripheral circuit in first semiconductor structure 102 use complementary metal-oxide-semiconductor (CMOS) technology. Both the Flash memory controller and the peripheral circuit can be implemented with advanced logic processes (e.g., technology nodes of 90 nm, 65 nm, 45 nm, 32 nm, 28 nm, 20 nm, 16 nm, 14 nm, 10 nm, 7 nm, 5 nm, 3 nm, *etc.)* to achieve high speed.

The Flash memory controller manages the data stored in NAND Flash memory and communicates with a host (e.g., a processor of a computing device or any other electronic devices). In some embodiments, the Flash memory controller is designed for operating in a low duty-cycle environment like Secure Digital (SD) cards, Compact Flash (CF) cards, USB Flash drives, or other media for use in electronic devices, such as personal computers, digital cameras, mobile phones, *etc.* In some embodiments, the Flash memory controller is designed for operating in a high duty-cycle environment like solid-state drives (SSDs) or embedded MultiMedia-Cards (eMMCs) used as data storage for mobile devices, such as smartphones, tablets, laptop computers, *etc.,* and enterprise storage arrays. The Flash memory controller is configured to control operations of Flash memory (i.e. the NAND memory in FIG. 1A), such as read, write, erase, and program operations. The Flash memory controller can also be configured to manage various functions with respect to the data stored or to be stored in the Flash memory including, but not limited to bad-block management, garbage collection, logical-to-physical address conversion, wear leveling, and so on. In some embodiments, the Flash memory controller is further configured to process error correction codes (ECCs) with respect to the data read from or written to the Flash memory. Any other suitable functions may be performed by the Flash memory controller as well, for example, formatting the Flash memory.

The peripheral circuit (also known as the control and sensing circuits) can include any suitable digital, analog, and/or mixed-signal circuits used for facilitating the operations of the NAND memory. For example, the peripheral circuit can include one or more of a page buffer, a decoder (e.g., a row decoder and a column decoder), a sense amplifier, a driver (e.g., a word line driver), a charge pump, a current or voltage reference, or any active or passive components of the circuit (e.g., transistors, diodes, resistors, or capacitors). According to the claimed invention the peripheral circuit includes one or more page buffers and word line drivers.

Memory device 100 also includes a second semiconductor structure 104 including the NAND memory having an array of NAND memory cells. That is, second semiconductor structure 104 is a NAND Flash memory in which memory cells are provided in the form of an array of 3D NAND memory strings and/or an array of 2D NAND memory cells. NAND memory cells can be organized into pages which are then organized into blocks, in which each NAND memory cell is electrically connected to a separate line called a bit line (BL). All cells with the same position in the NAND memory cell can be electrically connected through the control gates by a word line (WL). In some embodiments, a plane contains a certain number of blocks that are electrically connected through the same bit line. Second semiconductor structure 104 can include one or more planes, and the peripheral circuit that is needed to perform all the read/write/erase/program operations can be included in the first semiconductor structure 102 as described above.

In some embodiments, the array of NAND memory cells is an array of 2D NAND memory cells, each of which includes a floating-gate transistor. The array of 2D NAND memory cells includes a plurality of 2D NAND memory strings, each of which includes a plurality of memory cells (e.g., 32 to 128 memory cells) connected in series (resembling a NAND gate) and two select transistors, according to some embodiments. Each 2D NAND memory string is arranged in the same plane on the substrate (in 2D), according to some embodiments. In some embodiments, the array of NAND memory cells is an array of 3D NAND memory strings, each of which extends vertically above the substrate (in 3D) through a memory stack. Depending on the 3D NAND technology (e.g., the number of layers/tiers in the memory stack), a 3D NAND memory string typically includes 32 to 256 NAND memory cells, each of which includes a floating-gate transistor or a charge-trapping transistor.

As shown in FIG. 1A, memory device 100 further includes a bonding interface 106 vertically between a first semiconductor structure 102 and a second semiconductor structure 104. As described below in details, the first and second semiconductor structures 102 and 104 can be fabricated separately (and in parallel in some embodiments) such that the thermal budget of fabricating one of the first and second semiconductor structures 102 and 104 does not limit the processes of fabricating another one of the first and second semiconductor structures 102 and 104. Moreover, a large number of interconnects (e.g., bonding contacts) can be formed through bonding interface 106 to make direct, short electrical connections between first semiconductor structure 102 and second semiconductor structure 104, as opposed to the long-distance chip-to-chip data bus on the circuit board (e.g., Printed Circuit Board (PCB)), thereby avoiding chip interface delay and achieving high-speed In/Out (I/O) throughput with reduced power consumption. Data transfer between the NAND memory in second semiconductor structure 104 and the Flash memory controller in first semiconductor structure 102 can be performed through the interconnects (e.g., bonding contacts) across bonding interface 106. By vertically integrating first and second semiconductor structures 102 and 104, the chip size can be reduced, and the memory cell density can be increased. Furthermore, by integrating multiple discrete chips (e.g., Flash memory controller and NAND memory) into a single bonded chip (e.g., memory device 100), faster system speed and smaller PCB size can be achieved as well.

It is understood that the relative positions of stacked first and second semiconductor structures 102 and 104 are not limited. FIG. 1B illustrates a schematic view of a cross-section of another exemplary memory device 101, according to some embodiments. Different from memory device 100 in FIG. 1A in which second semiconductor structure 104 including the array of NAND memory cells is above first semiconductor structure 102 including the Flash memory controller and the peripheral circuit, in memory device 101 in FIG. 1B, first semiconductor structure 102 including the Flash memory controller and the peripheral circuit is above second semiconductor structure 104 including the array of NAND memory cells. Nevertheless, bonding interface 106 is formed vertically between first and second semiconductor structures 102 and 104 in memory device 101, and first and second semiconductor structures 102 and 104 are jointed vertically through bonding (e.g., hybrid bonding) according to some embodiments. Data transfer between the NAND memory in second semiconductor structure 104 and the Flash memory controller in first semiconductor structure 102 are performed through the interconnects (e.g., bonding contacts) across bonding interface 106.

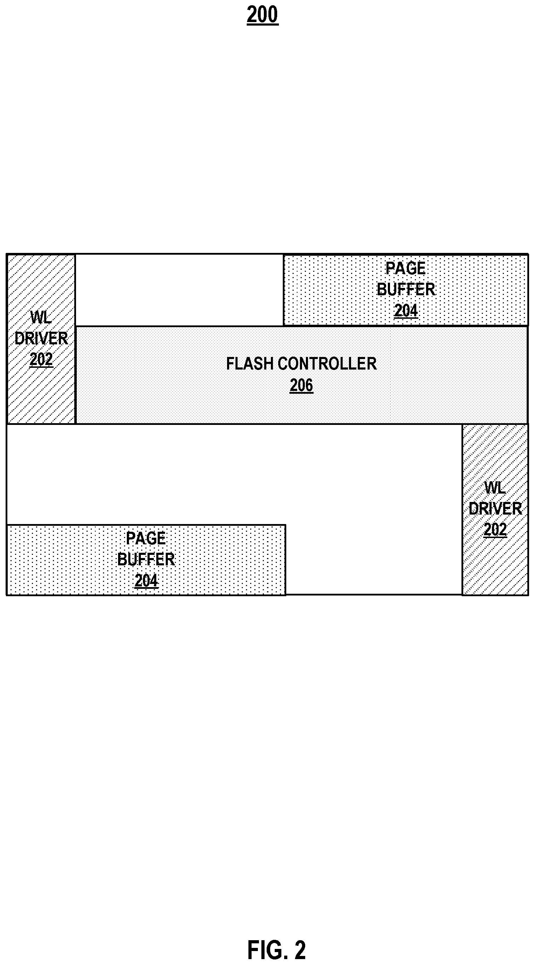

FIG. 2 illustrates a schematic plan view of an exemplary semiconductor structure 200 having a Flash memory controller 206, according to some embodiments. Semiconductor structure 200 may be one example of first semiconductor structure 102. Semiconductor structure 200 includes the peripheral circuit for controlling and sensing NAND memory, including word line drivers 202, page buffers 204, and any other suitable devices. Semiconductor structure 200 can further include Flash memory controller 206 on the same substrate as the peripheral circuit and fabricated using the same logic process as the peripheral circuit. FIG. 2 shows an exemplary layout of the peripheral circuit (e.g., word line drivers 202, page buffers 204) and Flash memory controller 206 in which peripheral circuit and Flash memory controller 206 are formed in different regions on the same plane. For example, the peripheral circuit may be formed outside of Flash memory controller 206. It is understood that the layout of semiconductor structure 200 is not limited to the exemplary layout in FIG. 2. According to the claimed invention, the peripheral circuit, and Flash memory controller 206 are stacked one over another, i.e. in different planes. Flash memory controller 206 is formed above or below the peripheral circuit to further reduce the chip size and therefore increase memory cell density.

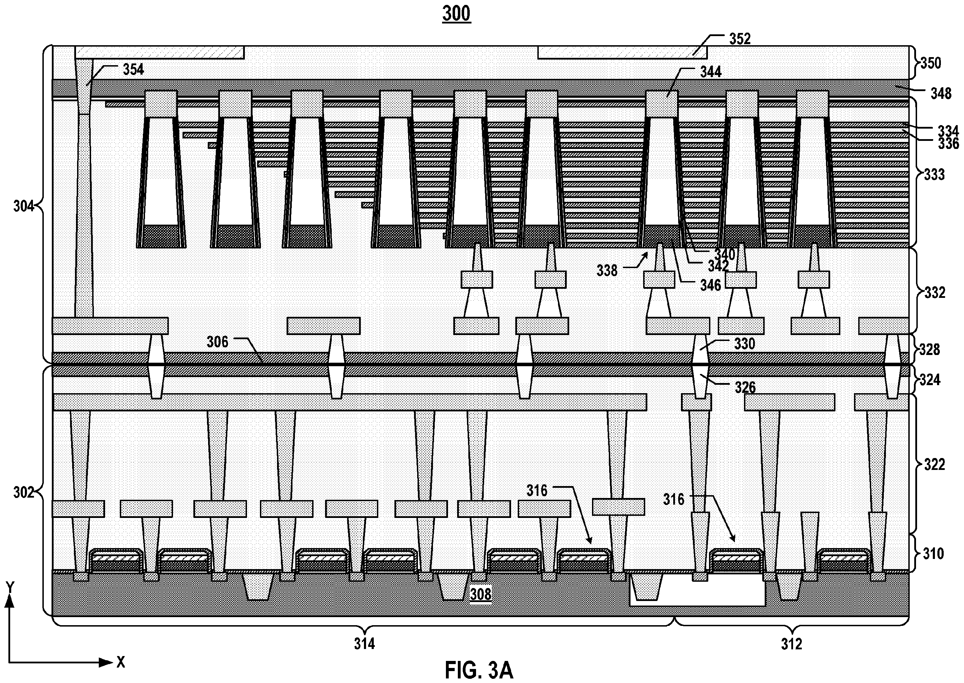

FIG. 3A illustrates a cross-section of an exemplary memory device 300 having 3D NAND memory, according to some embodiments. As one example of memory device 100 described above with respect to FIG. 1A, memory device 300 is a bonded chip including a first semiconductor structure 302 and a second semiconductor structure 304 stacked over first semiconductor structure 302. First and second semiconductor structures 302 and 304 are jointed at a bonding interface 306 therebetween, according to some embodiments. As shown in FIG. 3A, first semiconductor structure 302 can include a substrate 308, which can include silicon (e.g., single crystalline silicon), silicon germanium (SiGe), gallium arsenide (GaAs), germanium (Ge), silicon on insulator (SOI), or any other suitable materials.

First semiconductor structure 302 of memory device 300 can include a device layer 310 above substrate 308. It is noted that *x*- and *y*-axes are added in FIG. 3A to further illustrate the spatial relationship of the components in memory device 300. Substrate 308 includes two lateral surfaces (e.g., a top surface and a bottom surface) extending laterally in the x-direction (the lateral direction or width direction). As used herein, whether one component (e.g., a layer or a device) is "on," "above," or "below" another component (e.g., a layer or a device) of a semiconductor device (e.g., memory devices 300) is determined relative to the substrate of the semiconductor device (e.g., substrate 308) in the *y*-direction (the vertical direction or thickness direction) when the substrate is positioned in the lowest plane of the semiconductor device in the *y*-direction. The same notion for describing the spatial relationship is applied throughout the present disclosure.

In some embodiments, device layer 310 includes a Flash memory controller 312 on substrate 308 and a peripheral circuit 314 on substrate 308 and outside of Flash memory controller 312. In some embodiments, Flash memory controller 312 includes a plurality of logic transistors 316 forming any suitable components thereof as described below in details. In some embodiments, logic transistors 316 further form peripheral circuit 314, e.g., any suitable digital, analog, and/or mixed-signal control and sensing circuits used for facilitating the operation of the 3D NAND memory including, but not limited to, a page buffer, a decoder (e.g., a row decoder and a column decoder), a sense amplifier, a driver (e.g., a word line driver), a charge pump, a current or voltage reference. Logic transistors 316 can be formed "on" substrate 308, in which the entirety or part of logic transistors 316 are formed in substrate 308 (e.g., below the top surface of substrate 308) and/or directly on substrate 308. Isolation regions (e.g., shallow trench isolations (STIs)) and doped regions (e.g., source regions and drain regions of logic transistors 316) can be formed in substrate 308 as well. Logic transistors 316 are high-speed logic transistors with advanced logic processes (e.g., technology nodes of 90 nm, 65 nm, 55 nm, 45 nm, 32 nm, 28 nm, 20 nm, 16 nm, 14 nm, 10 nm, 7 nm, 5 nm, 3 nm, *etc.),* according to some embodiments.

In accordance with the claimed invention, first semiconductor structure 302 of memory device 300 further includes an interconnect layer 322 above device layer 310 to transfer electrical signals to and from Flash memory controller 312 and peripheral circuit 314. Interconnect layer 322 includes a plurality of interconnects (also referred to herein as "contacts"), including lateral interconnect lines and vertical interconnect access (via) contacts. As used herein, the term "interconnects" can broadly include any suitable types of interconnects, such as middle-end-of-line (MEOL) interconnects and back-end-of-line (BEOL) interconnects. Interconnect layer 322 can further include one or more inter-layer dielectric (ILD) layers (also known as "inter-metal dielectric (IMD) layers" for BEOL) in which the interconnect lines and via contacts can form. That is, interconnect layer 322 can include interconnect lines and via contacts in multiple interlayer dielectric (ILD) layers. The interconnect lines and via contacts in interconnect layer 322 can include conductive materials including, but not limited to, tungsten (W), cobalt (Co), copper (Cu), aluminum (Al), silicides, or any combination thereof. The ILD layers in interconnect layer 322 can include dielectric materials including, but not limited to, silicon oxide, silicon nitride, silicon oxynitride, low dielectric constant (low-k) dielectrics, or any combination thereof.

In accordance with the claimed invention, the devices in device layer 310 are electrically connected to one another through the interconnects in interconnect layer 322.Peripheral circuit 314 is electrically connected to Flash memory controller 312 through interconnect layer 322.

As shown in FIG. 3A, first semiconductor structure 302 of memory device 300 further includes a bonding layer 324 at bonding interface 306 and above interconnect layer 322 and device layer 310 (Flash memory controller 312 and peripheral circuit 314). Bonding layer 324 includes a plurality of bonding contacts 326 and dielectrics electrically isolating bonding contacts 326. Bonding contacts 326 can include conductive materials including, but not limited to, W, Co, Cu, Al, silicides, or any combination thereof. The remaining area of bonding layer 324 can be formed with dielectrics including, but not limited to, silicon oxide, silicon nitride, silicon oxynitride, low-k dielectrics, or any combination thereof.

Similarly, as shown in FIG. 3A, second semiconductor structure 304 of memory device 300 also includes a bonding layer 328 at bonding interface 306 and above bonding layer 324 of first semiconductor structure 302. Bonding layer 328 can include a plurality of bonding contacts 330 and dielectrics electrically isolating bonding contacts 330. Bonding contacts 330 can include conductive materials including, but not limited to, W, Co, Cu, Al, silicides, or any combination thereof. The remaining area of bonding layer 328 can be formed with dielectrics including, but not limited to, silicon oxide, silicon nitride, silicon oxynitride, low-k dielectrics, or any combination thereof.

As described above, second semiconductor structure 304 can be bonded on top of first semiconductor structure 302 in a face-to-face manner at bonding interface 306. According to the invention, bonding interface 306 is disposed between bonding layers 324 and 328 as a result of hybrid bonding (also known as "metal/dielectric hybrid bonding"), which is a direct bonding technology (e.g., forming bonding between surfaces without using intermediate layers, such as solder or adhesives) and can obtain metal-metal bonding and dielectric-dielectric bonding simultaneously. According to the claimed invention, bonding interface 306 is the place at which bonding layers 324 and 328 are met and bonded. In practice, bonding interface 306 can be a layer with a certain thickness that includes the top surface of bonding layer 324 of first semiconductor structure 302 and the bottom surface of bonding layer 328 of second semiconductor structure 304.

According to the claimed invention, second semiconductor structure 304 of memory device 300 further includes an interconnect layer 332 above bonding layer 328 to transfer electrical signals. Interconnect layer 332 can include a plurality of interconnects, such as MEOL interconnects and BEOL interconnects. Interconnect layer 332 can further include one or more ILD layers in which the interconnect lines and via contacts can form. The interconnect lines and via contacts in interconnect layer 332 can include conductive materials including, but not limited to, W, Co, Cu, Al, silicides, or any combination thereof. The ILD layers in interconnect layer 332 can include dielectric materials including, but not limited to, silicon oxide, silicon nitride, silicon oxynitride, low-k dielectrics, or any combination thereof.

In some embodiments, second semiconductor structure 304 of memory device 300 includes a NAND Flash memory in which memory cells are provided in the form of an array of 3D NAND memory strings 338 above interconnect layer 332 and bonding layer 328. Each 3D NAND memory string 338 extends vertically through a plurality of pairs each including a conductor layer 334 and a dielectric layer 336, according to some embodiments. The stacked and interleaved conductor layers 334 and dielectric layer 336 are also referred to herein as a memory stack 333. Interleaved conductor layers 334 and dielectric layers 336 in memory stack 333 alternate in the vertical direction, according to some embodiments. In other words, except the ones at the top or bottom of memory stack 333, each conductor layer 334 can be adjoined by two dielectric layers 336 on both sides, and each dielectric layer 336 can be adjoined by two conductor layers 334 on both sides. Conductor layers 334 can each have the same thickness or different thicknesses. Similarly, dielectric layers 336 can each have the same thickness or different thicknesses. Conductor layers 334 can include conductor materials including, but not limited to, W, Co, Cu, Al, doped silicon, silicides, or any combination thereof. Dielectric layers 336 can include dielectric materials including, but not limited to, silicon oxide, silicon nitride, silicon oxynitride, or any combination thereof.

In some embodiments, each 3D NAND memory string 338 is a "charge trap" type of NAND memory string including a semiconductor channel 342 and a memory film 340. In some embodiments, semiconductor channel 342 includes silicon, such as amorphous silicon, polysilicon, or single crystalline silicon. In some embodiments, memory film 340 is a composite dielectric layer including a tunneling layer, a storage layer (also known as "charge trap/storage layer"), and a blocking layer. Each 3D NAND memory string 338 can have a cylinder shape (e.g., a pillar shape). Semiconductor channel 342, the tunneling layer, the storage layer, and the blocking layer of memory film 340 are arranged along a direction from the center toward the outer surface of the pillar in this order, according to some embodiments. The tunneling layer can include silicon oxide, silicon oxynitride, or any combination thereof. The storage layer can include silicon nitride, silicon oxynitride, silicon, or any combination thereof. The blocking layer can include silicon oxide, silicon oxynitride, high dielectric constant (high-k) dielectrics, or any combination thereof. In one example, the blocking layer can include a composite layer of silicon oxide/silicon oxynitride/silicon oxide (ONO). In another example, the blocking layer can include a high-k dielectric layer, such as aluminum oxide (Al₂O₃), hafnium oxide (HfO₂) or tantalum oxide (Ta₂O₅) layer, and so on.

In some embodiments, 3D NAND memory strings 338 further include a plurality of control gates (each being part of a word line). Each conductor layer 334 in memory stack 333 can act as a control gate for each memory cell of 3D NAND memory string 338. In some embodiments, each 3D NAND memory string 338 includes two plugs 344 and 346 at respective end in the vertical direction. Plug 344 can include a semiconductor material, such as single-crystal silicon, that is epitaxially grown from a semiconductor layer 348. Plug 344 can function as the channel controlled by a source select gate of 3D NAND memory string 338. Plug 344 can be at the upper end of 3D NAND memory string 338 and in contact with semiconductor channel 342. As used herein, the "upper end" of a component (e.g., 3D NAND memory string 338) is the end father away from substrate 308 in the *y*-direction, and the "lower end" of the component (e.g., 3D NAND memory string 338) is the end closer to substrate 308 in the *y*-direction when substrate 308 is positioned in the lowest plane of memory device 300. Another Plug 346 can include semiconductor materials (e.g., polysilicon) or conductor materials (e.g., metals). In some embodiments, plug 346 includes an opening filled with titanium/titanium nitride (Ti/TiN, as a glue layer) and tungsten (as a conductor). By covering the upper end of 3D NAND memory string 338 during the fabrication of second semiconductor structure 304, plug 346 can function as an etch stop layer to prevent etching of dielectrics filled in 3D NAND memory string 338, such as silicon oxide and silicon nitride. In some embodiments, plug 346 functions as the drain of 3D NAND memory string 338.

In some embodiments, second semiconductor structure 304 further includes semiconductor layer 348 disposed above memory stack 333 and 3D NAND memory strings 338. Semiconductor layer 348 can be a thinned substrate on which memory stack 333 and 3D NAND memory strings 338 are formed. In some embodiments, semiconductor layer 348 includes single-crystal silicon from which plugs 344 can be epitaxially grown. In some embodiments, semiconductor layer 348 can include polysilicon, amorphous silicon, SiGe, GaAs, Ge, Salicide, or any other suitable materials. Semiconductor layer 348 can also include isolation regions and doped regions (e.g., functioning as an array common source (ACS) for 3D NAND memory strings 338, not shown). Isolation regions (not shown) can extend across the entire thickness or part of the thickness of semiconductor layer 348 to electrically isolate the doped regions. In some embodiments, a pad oxide layer including silicon oxide is disposed between memory stack 333 and semiconductor layer 348.

It is understood that 3D NAND memory strings 338 are not limited to the "charge trap" type of 3D NAND memory strings and may be "floating gate" type of 3D NAND memory strings in other embodiments. Semiconductor layer 348 may include polysilicon as the source plate of the "floating gate" type of 3D NAND memory strings.

As shown in FIG. 3A, second semiconductor structure 304 of memory device 300 can further include a pad-out interconnect layer 350 above semiconductor layer 348. Pad-out interconnect layer 350 include interconnects, e.g., contact pads 352, in one or more ILD layers. Pad-out interconnect layer 350 and interconnect layer 332 can be formed at opposite sides of semiconductor layer 348. In some embodiments, the interconnects in pad-out interconnect layer 350 can transfer electrical signals between memory device 300 and outside circuits, e.g., for pad-out purposes.

In some embodiments, second semiconductor structure 304 further includes one or more contacts 354 extending through semiconductor layer 348 to electrically connect pad-out interconnect layer 350 and interconnect layers 332 and 322. As a result, Flash memory controller 312 can be electrically connected to array of 3D NAND memory strings 338 through interconnect layers 322 and 332 as well as bonding contacts 326 and 330. Peripheral circuit 314 is also electrically connected to array of 3D NAND memory strings 338 through interconnect layers 322 and 332 as well as bonding contacts 326 and 330. Moreover, Flash memory controller 312, peripheral circuit 314, and array of 3D NAND memory strings 338 can be electrically connected to outside circuits through contacts 354 and pad-out interconnect layer 350.

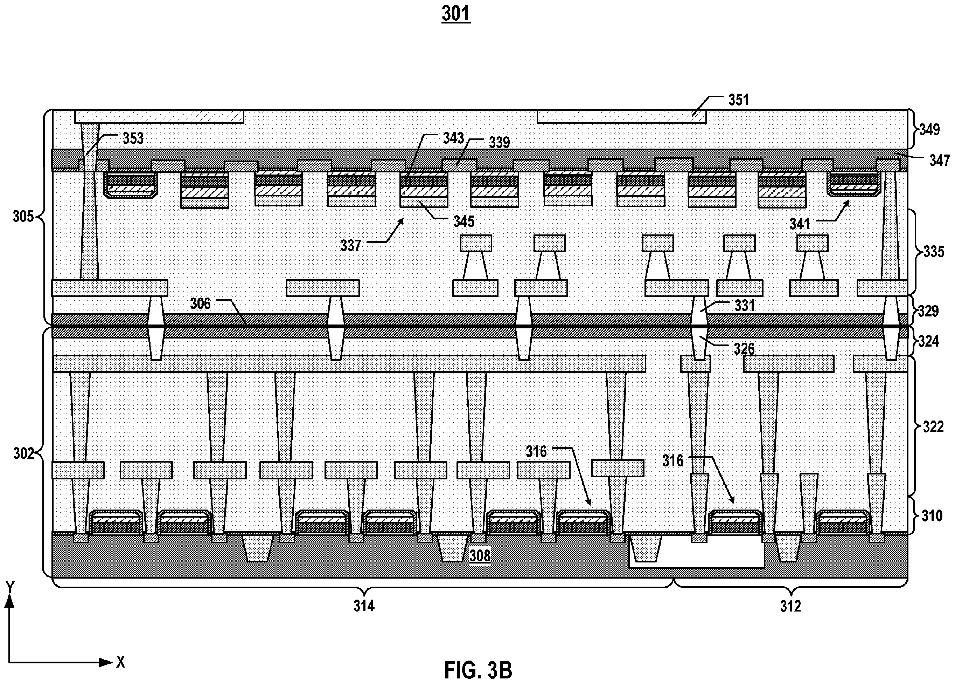

FIG. 3B illustrates a cross-section of an exemplary memory device 301 having 2D NAND memory, according to some embodiments. Similar to memory device 300 described above in FIG. 3A, memory device 301 represents an example of a bonded chip including first semiconductor structure 302 having Flash memory controller 312 and peripheral circuit 314. Different from memory device 300 described above in FIG. 3A that includes second semiconductor structure 304 having 3D NAND memory strings 338, memory device 301 in FIG. 3B includes a second semiconductor structure 305 having 2D NAND memory cells 337. Similar to memory device 300 described above in FIG. 3A, first and second semiconductor structures 302 and 305 of memory device 301 are bonded in a face-to-face manner at bonding interface 306, as shown in FIG. 3B. It is understood that the details of similar structures (e.g., materials, fabrication process, functions, *etc.)* in both memory devices 300 and 301 may not be repeated below.

Similarly, as shown in FIG. 3B, second semiconductor structure 305 of memory device 301 also includes a bonding layer 329 at bonding interface 306 and above bonding layer 324 of first semiconductor structure 302. Bonding layer 329 includes a plurality of bonding contacts 331 and dielectrics electrically isolating bonding contacts 331. Bonding contacts 331 and surrounding dielectrics in bonding layer 329 are used for hybrid bonding. According to the claimed invention, second semiconductor structure 305 of memory device 301 further includes an interconnect layer 335 above bonding layer 329 to transfer electrical signals. Interconnect layer 335 can include a plurality of interconnects, such as MEOL interconnects and BEOL interconnects. Interconnect layer 335 can further include one or more ILD layers in which the interconnect lines and via contacts can form.

In some embodiments, second semiconductor structure 305 of memory device 301 includes a NAND Flash memory in which memory cells are provided in the form of an array of 2D NAND memory cells 337 above interconnect layer 335 and bonding layer 329. Array of 2D NAND memory cells 337 can include a plurality of 2D NAND memory strings, each of which includes a plurality of memory cells 337 connected in series by sources/drains 339 (resembling a NAND gate) and two select transistors 341 at the ends of the 2D NAND memory string, respectively. In some embodiments, each 2D NAND memory string further includes one or more select gates and/or dummy gates besides select transistors 314. In some embodiments, each 2D NAND memory cell 337 includes a floating-gate transistor having a floating gate 343 and a control gate 345 stacked vertically. Floating gate 343 can include semiconductor materials, such as polysilicon. Control gate 345 can be part of the word line of the NAND Flash memory device and include conductive materials including, but not limited to, W, Co, Cu, Al, doped polysilicon, silicides, or any combination thereof. In some embodiments, the floating-gate transistor further includes dielectric layers, such as a blocking layer disposed vertically between control gate 345 and floating gate 343 and a tunneling layer disposed above floating gate 343. The blocking layer can include silicon oxide, silicon oxynitride, high-k dielectrics, or any combination thereof. The tunneling layer can include silicon oxide, silicon oxynitride, or a combination thereof. Channels can be formed laterally between sources/drains 339 and above the gate stacks (including the tunneling layer, floating gate 343, the blocking layer, and control gate 345). Each channel is controlled by the voltage signal applied to the corresponding gate stack through control gate 345, according to some embodiments. It is understood that 2D NAND memory cell 337 may include a charge-trap transistor, which replaces floating gate 343 with a storage layer as described above in details. In some embodiments, the storage layer includes silicon nitride, silicon oxynitride, or any combination thereof and has a thickness smaller than that of floating gate 343.

In some embodiments, second semiconductor structure 305 further includes semiconductor layer 347 disposed above and in contact with array of 2D NAND memory cells 337. Semiconductor layer 347 can be a thinned substrate on which 2D NAND memory cells 337 are formed. In some embodiments, semiconductor layer 347 includes single-crystal silicon. In some embodiments, semiconductor layer 347 includes polysilicon, amorphous silicon, SiGe, GaAs, Ge, Salicide, or any other suitable materials. Semiconductor layer 347 can also include isolation regions and doped regions (e.g., functioning as sources/drains 339 of 2D NAND memory cells 337).

As shown in FIG. 3B, second semiconductor structure 305 of memory device 301 can further include a pad-out interconnect layer 349 above semiconductor layer 347. Pad-out interconnect layer 349 includes interconnects, e.g., contact pads 351, in one or more ILD layers, according to some embodiments. Pad-out interconnect layer 349 and interconnect layer 335 can be formed at opposite sides of semiconductor layer 347. The interconnects in pad-out interconnect layer 349 can transfer electrical signals between memory device 301 and outside circuits, e.g., for pad-out purposes.

In some embodiments, second semiconductor structure 305 further includes one or more contacts 353 extending vertically through semiconductor layer 347 to electrically connect pad-out interconnect layer 349 and interconnect layers 335 and 322. As a result, Flash memory controller 312 can be electrically connected to 2D NAND memory cells 337 through interconnect layers 322 and 335 as well as bonding contacts 326 and 331. Peripheral circuit 314 is electrically connected to 2D NAND memory cells 337 through interconnect layers 322 and 335 as well as bonding contacts 326 and 331. Moreover, Flash memory controller 312, peripheral circuit 314, and 2D NAND memory cells 337 can be electrically connected to outside circuits through contacts 353 and pad-out interconnect layer 349.

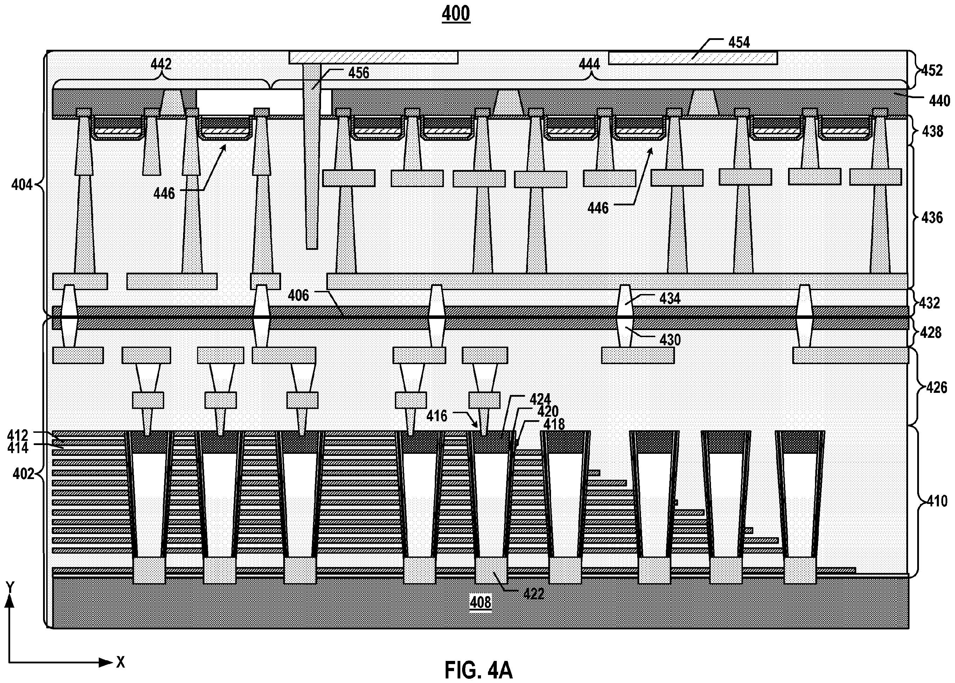

FIG. 4A illustrates a cross-section of another exemplary memory device 400 having 3D NAND memory, according to some embodiments. Similar to memory device 300 described above in FIG. 3A, memory device 400 represents an example of a bonded chip in which a first semiconductor structure 402 including 3D NAND memory strings and a second semiconductor structure 404 including a Flash memory controller and a peripheral circuit of the 3D NAND memory strings are formed separately and bonded in a face-to-face manner at a bonding interface 406. Different from memory device 300 described above in FIG. 3A in which first semiconductor structure 302 including the Flash memory controller and the peripheral circuit is below second semiconductor structure 304 including the 3D NAND memory strings, memory device 400 in FIG. 4A includes second semiconductor structure 404 including a Flash memory controller and a peripheral circuit disposed above first semiconductor structure 402 including 3D NAND memory strings. It is understood that the details of similar structures (e.g., materials, fabrication process, functions, *etc.)* in both memory devices 300 and 400 may not be repeated below.

First semiconductor structure 402 of memory device 400 can include a substrate 408 and a memory stack 410 including interleaved conductor layers 412 and dielectric layers 414 above substrate 408. In some embodiments, an array of 3D NAND memory cells 416 each extends vertically through interleaved conductor layers 412 and dielectric layers 414 in memory stack 410 above substrate 408. Each 3D NAND memory cell 416 can include a semiconductor channel layer 420 and a memory film 418. Each 3D NAND memory cell 416 further includes two plugs 422 and 424 at its lower end and upper end, respectively. 3D NAND memory cells 416 can be "charge trap" type of 3D NAND memory strings or "floating gate" type of 3D NAND memory strings. In some embodiments, a pad oxide layer including silicon oxide is disposed between memory stack 410 and substrate 408.

In some embodiments, first semiconductor structure 402 of memory device 400 also includes an interconnect layer 426 above memory stack 410 and 3D NAND memory cells 416 to transfer electrical signals to and from 3D NAND memory cells 416. Interconnect layer 426 can include a plurality of interconnects, including interconnect lines and via contacts. In some embodiments, the interconnects in interconnect layer 426 also include local interconnects, such as bit line contacts and word line contacts. In some embodiments, first semiconductor structure 402 of memory device 400 further includes a bonding layer 428 at bonding interface 406 and above interconnect layer 426 and memory stack 410. Bonding layer 428 can include a plurality of bonding contacts 430 and dielectrics surrounding and electrically isolating bonding contacts 430.

As shown in FIG. 4A, second semiconductor structure 404 of memory device 400 includes another bonding layer 432 at bonding interface 406 and above bonding layer 428. Bonding layer 432 can include a plurality of bonding contacts 434 and dielectrics surrounding and electrically isolating bonding contacts 434. In some embodiments, second semiconductor structure 404 of memory device 400 also includes an interconnect layer 436 above bonding layer 432 to transfer electrical signals. Interconnect layer 436 can include a plurality of interconnects, including interconnect lines and via contacts.

Second semiconductor structure 404 of memory device 400 can further include a device layer 438 above interconnect layer 436 and bonding layer 432. According to the claimed invention, device layer 438 includes a Flash memory controller 442 above interconnect layer 436 and bonding layer 432 and a peripheral circuit 444 above interconnect layer 436 and bonding layer 432 and outside of Flash memory controller 442.

According to the claimed invention, the devices in device layer 438 are electrically connected to one another through the interconnects in interconnect layer 436.Peripheral circuit 444 is electrically connected to Flash memory controller 442 through interconnect layer 436. In some embodiments, Flash memory controller 442 includes a plurality of logic transistors 446 forming any suitable components thereof as described below in detail. Device layer 438 can also include peripheral circuit 444 of the 3D NAND memory formed by logic transistors 446 as described above in detail. Logic transistors 446 can be formed "on" a semiconductor layer 440, in which the entirety or part of logic transistors 446 are formed in semiconductor layer 440 and/or directly on semiconductor layer 440. Isolation regions (e.g., STIs) and doped regions (e.g., source regions and drain regions of logic transistors 446) can be formed in semiconductor layer 440 as well.

In some embodiments, second semiconductor structure 404 further includes semiconductor layer 440 disposed above device layer 438. Semiconductor layer 440 can be a thinned substrate on which logic transistors 446 are formed. In some embodiments, semiconductor layer 440 includes single-crystal silicon. In some embodiments, semiconductor layer 440 can include polysilicon, amorphous silicon, SiGe, GaAs, Ge, Salicide, or any other suitable materials. Semiconductor layer 440 can also include isolation regions and doped regions.

As shown in FIG. 4A, second semiconductor structure 404 of memory device 400 can further include a pad-out interconnect layer 452 above semiconductor layer 440. Pad-out interconnect layer 452 include interconnects, e.g., contact pads 454, in one or more ILD layers. In some embodiments, the interconnects in pad-out interconnect layer 452 can transfer electrical signals between memory device 400 and outside circuits, e.g., for pad-out purposes. In some embodiments, second semiconductor structure 404 further includes one or more contacts 456 extending through semiconductor layer 440 to electrically connect pad-out interconnect layer 452 and interconnect layers 436 and 426. As a result, Flash memory controller 442 can be electrically connected to array of 3D NAND memory cells 416 through interconnect layers 426 and 436 as well as bonding contacts 430 and 434. Peripheral circuit 444 is electrically connected to array of 3D NAND memory cells 416 through interconnect layers 426 and 436 as well as bonding contacts 430 and 434. Moreover, Flash memory controller 442, peripheral circuit 444, and array of 3D NAND memory cells 416 can be electrically connected to outside circuits through contacts 456 and pad-out interconnect layer 452.

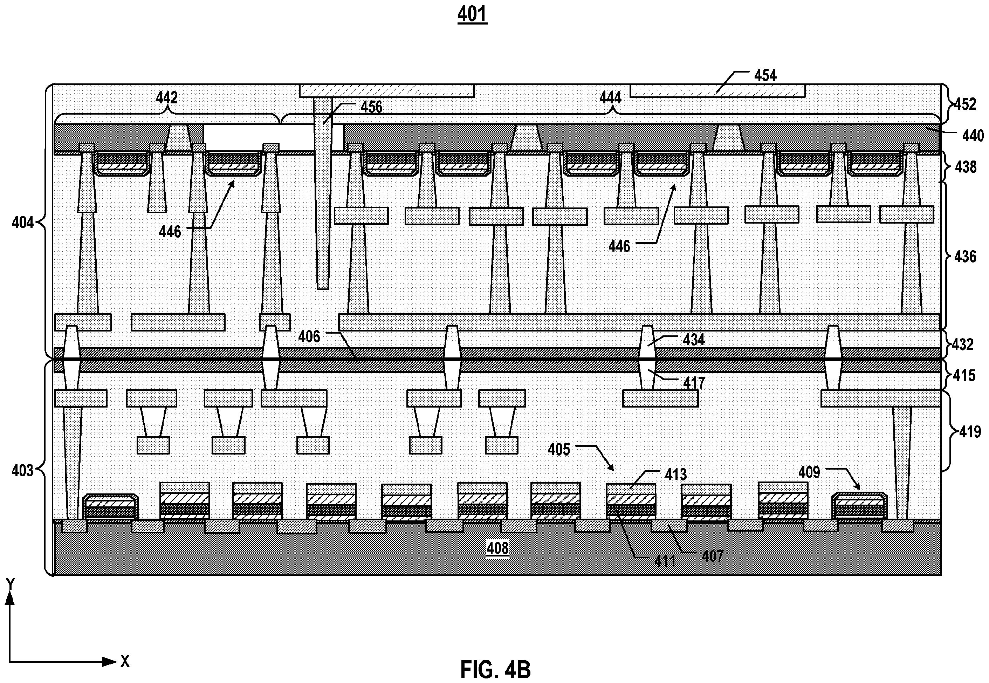

FIG. 4B illustrates a cross-section of another exemplary memory device 401 having 2D NAND memory, according to some embodiments. Similar to memory device 400 described above in FIG. 4A, memory device 401 represents an example of a bonded chip including second semiconductor structure 404 having Flash memory controller 442 and peripheral circuit 444. Different from memory device 400 described above in FIG. 4A that includes first semiconductor structure 402 having 3D NAND memory cells 416, memory device 401 in FIG. 4B includes a first semiconductor structure 403 having 2D NAND memory cells 405. Similar to memory device 400 described above in FIG. 4A, first and second semiconductor structures 403 and 404 of memory device 401 are bonded in a face-to-face manner at bonding interface 406, as shown in FIG. 4B. It is understood that the details of similar structures (e.g., materials, fabrication process, functions, *etc.)* in both memory devices 400 and 401 may not be repeated below.

In some embodiments, first semiconductor structure 403 of memory device 401 includes a NAND Flash memory in which memory cells are provided in the form of an array of 2D NAND memory cells 405 on substrate 408. Array of 2D NAND memory cells 405 can include a plurality of 2D NAND memory strings, each of which includes a plurality of memory cells connected in series by sources/drains 407 (resembling a NAND gate) and two select transistors 409 at the ends of the 2D NAND memory string, respectively. In some embodiments, each 2D NAND memory cell 405 includes a floating-gate transistor having a floating gate 411 and a control gate 413 stacked vertically. In some embodiments, the floating-gate transistor further includes dielectric layers, such as a blocking layer disposed vertically between control gate 413 and floating gate 411 and a tunneling layer disposed below floating gate 411. Channels can be formed laterally between sources/drains 407 and below the gate stacks (including the tunneling layer, floating gate 411, the blocking layer, and control gate 413). Each channel is controlled by the voltage signal applied to the corresponding gate stack through control gate 413, according to some embodiments. It is understood that 2D NAND memory cell 405 may include a charge-trap transistor, which replaces floating gate 411 with a storage layer as described above in details.

In some embodiments, first semiconductor structure 403 of memory device 401 also includes an interconnect layer 419 above 2D NAND memory cells 405 to transfer electrical signals to and from 2D NAND memory cells 405. Interconnect layer 419 can include a plurality of interconnects, including interconnect lines and via contacts. In some embodiments, interconnects in interconnect layer 419 also include local interconnects, such as bit line contacts and word line contacts. In some embodiments, first semiconductor structure 403 of memory device 401 further includes a bonding layer 415 at bonding interface 406 and above interconnect layer 419 and 2D NAND memory cells 405. Bonding layer 415 can include a plurality of bonding contacts 417 and dielectrics surrounding and electrically isolating bonding contacts 417.

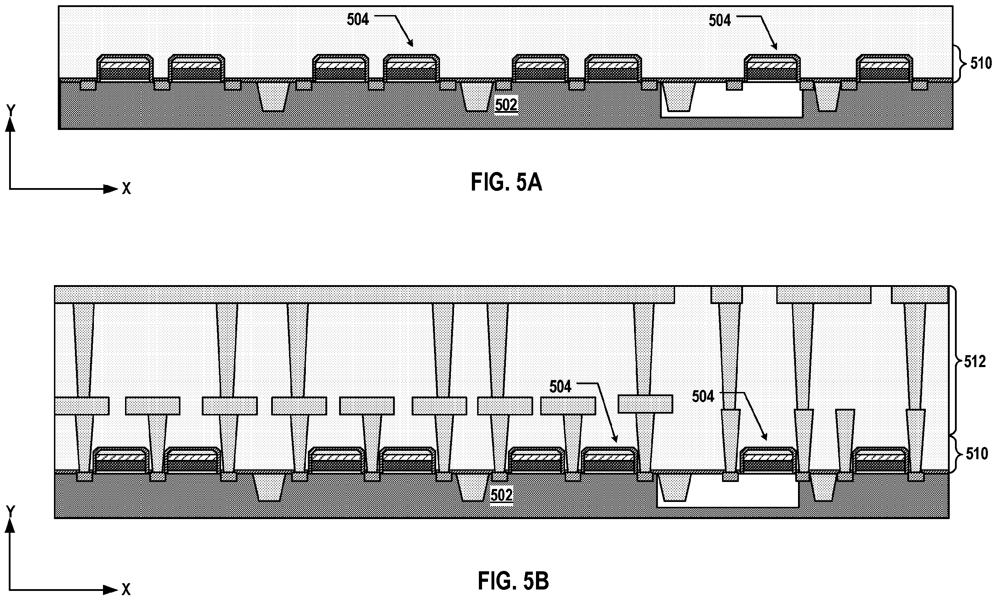

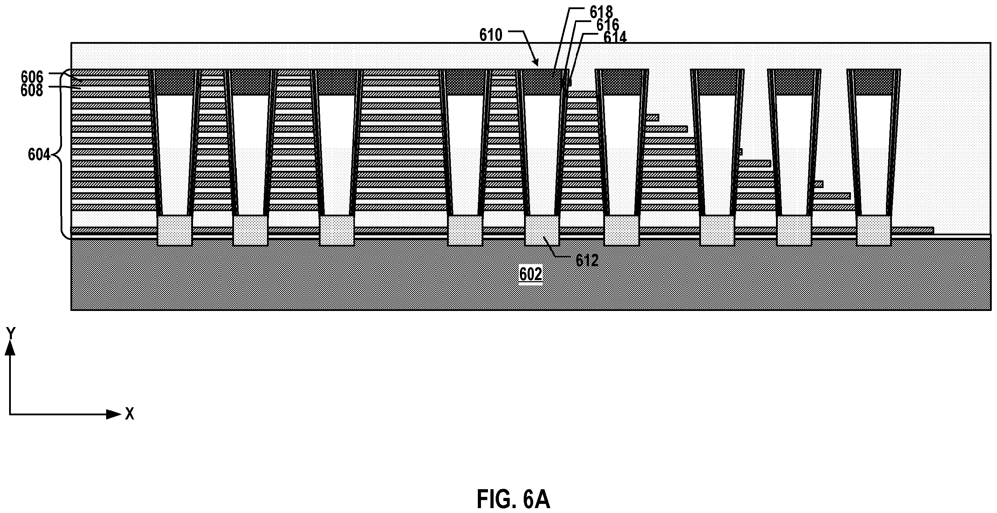

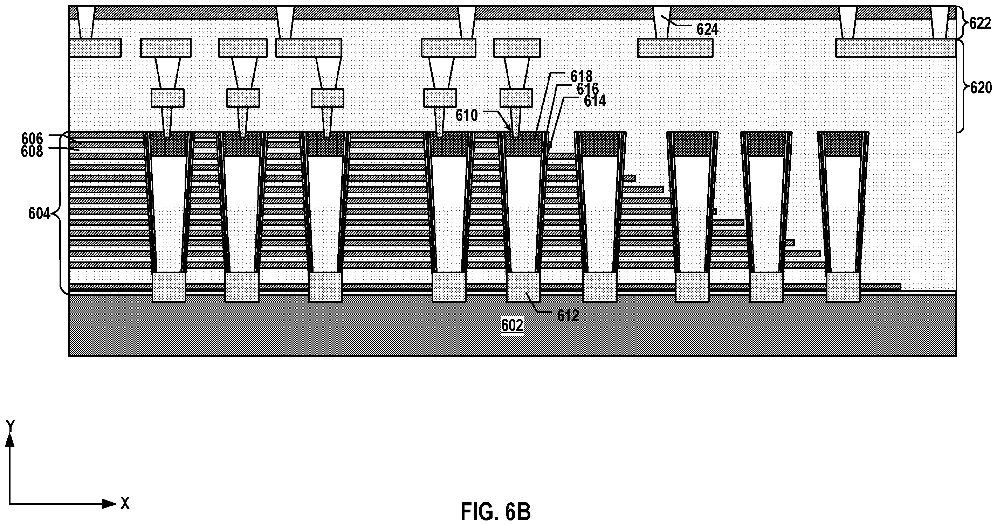

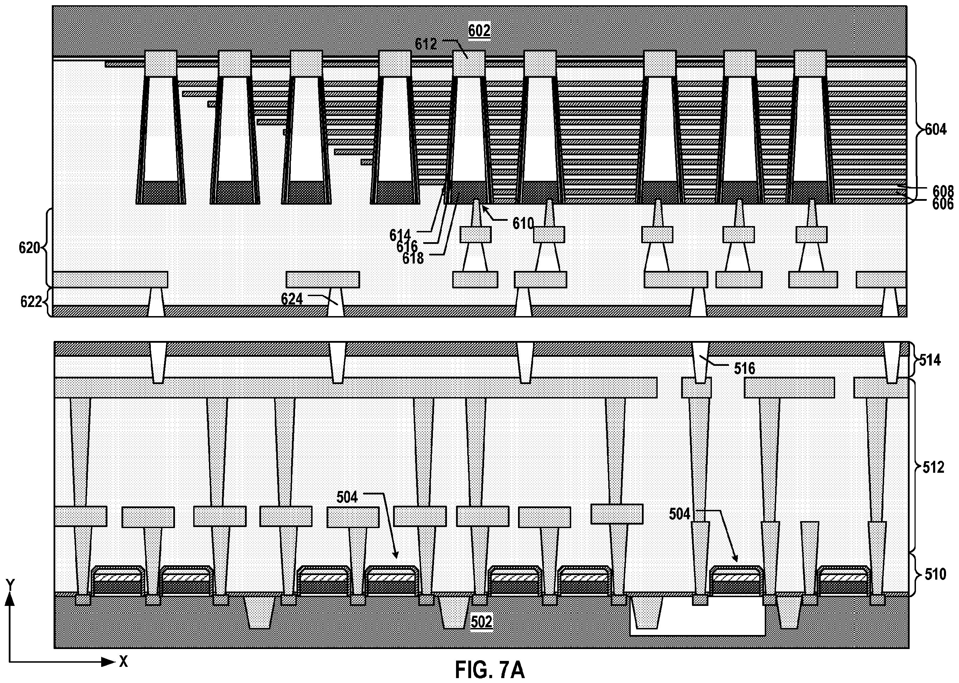

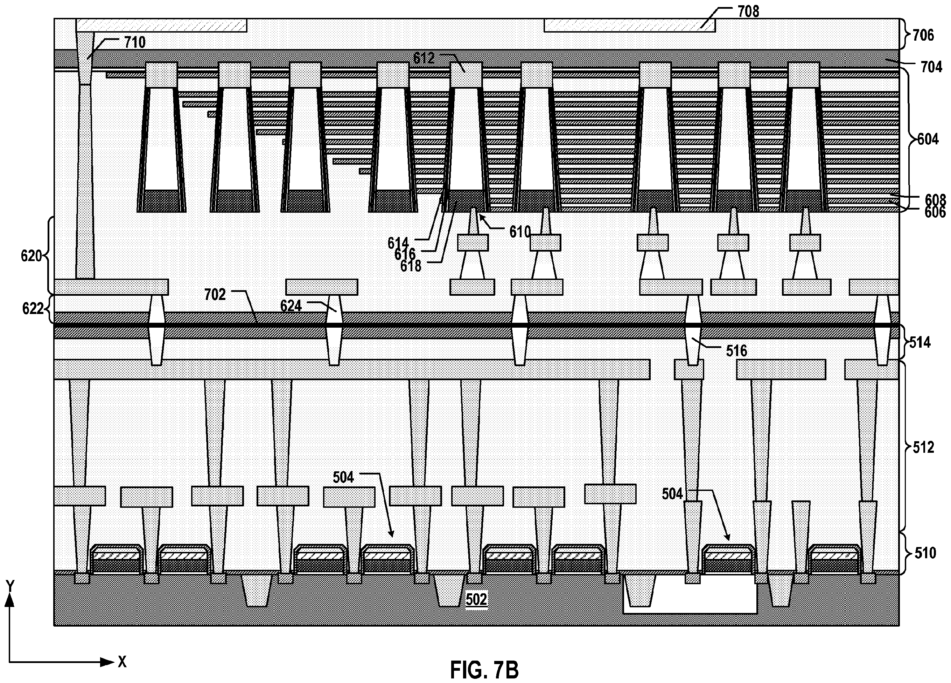

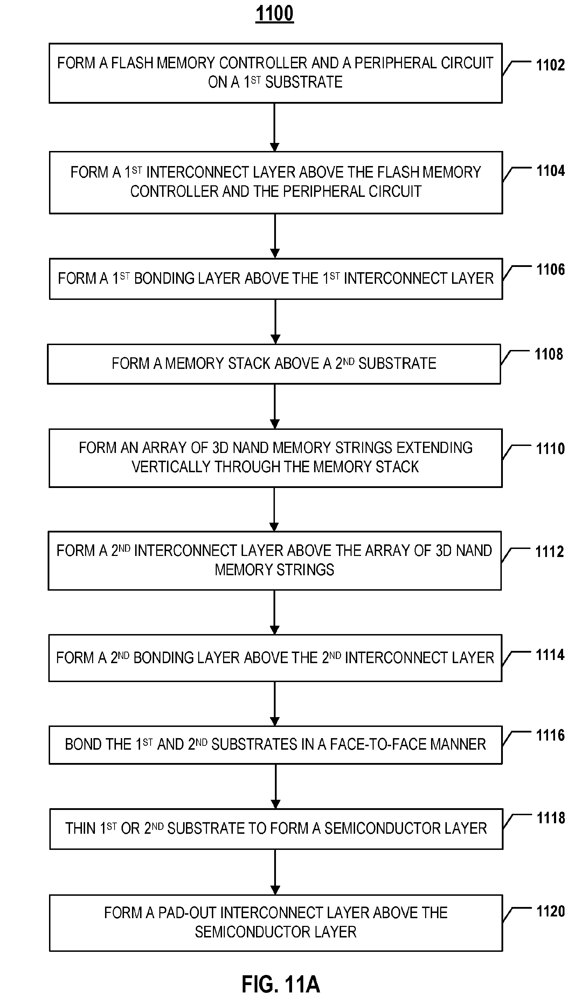

FIGs. 5A-5C illustrate a fabrication process for forming an exemplary semiconductor structure having a Flash memory controller, according to some embodiments. FIGs. 6A and 6B illustrate a fabrication process for forming an exemplary semiconductor structure having 3D NAND memory strings, according to some embodiments. FIGs. 7A and 7B illustrate a fabrication process for forming an exemplary memory device, according to some embodiments. FIG. 11A is a flowchart of an exemplary method 1100 for forming a memory device, according to some embodiments. Examples of the memory device depicted in FIGs. 5A-5C, 6A, 6B, 7A, 7B, and 11A include memory device 300 depicted in FIG. 3A and memory device 400 depicted in FIG. 4A. FIGs. 5A-5C, 6A, 6B, 7A, 7B, and 11A will be described together. It is understood that the operations shown in method 1100 are not exhaustive and that other operations can be performed as well before, after, or between any of the illustrated operations. Further, some of the operations may be performed simultaneously, or in a different order than shown in FIG. 11A.

As depicted in FIGs. 5A-5C, a first semiconductor structure including a Flash memory controller, a peripheral circuit, and a first bonding layer including a plurality of first bonding contacts is formed. The Flash memory controller includes a host interface operatively coupled to a host processor, a NAND memory interface operatively coupled to the array of NAND memory cells, a management module, and an ECC module. As depicted in FIGs. 6A and 6B, a second semiconductor structure including an array of 3D NAND memory strings and a second bonding layer including a plurality of second bonding contacts is formed. The peripheral circuit includes one or more page buffers and word line drivers of the array of 3D NAND memory strings. As depicted in FIGs. 7A and 7B, the first semiconductor structure and the second semiconductor structure are bonded in a face-to-face manner, such that the first bonding contacts are in contact with the second bonding contacts at a bonding interface.

Referring to FIG. 11A, method 1100 starts at operation 1102, in which the Flash memory controller and the peripheral circuit are formed on a first substrate. The first substrate can be a silicon substrate. In some embodiments, to form the Flash memory controller and the peripheral circuit, a plurality of transistors are formed on the first substrate.

As illustrated in FIG. 5A, a plurality of logic transistors 504 are formed on a silicon substrate 502. Logic transistors 504 can be formed by a plurality of processes including, but not limited to, photolithography, dry/wet etch, thin film deposition, thermal growth, implantation, chemical mechanical polishing (CMP), and any other suitable processes. In some embodiments, doped regions are formed in silicon substrate 502 by ion implantation and/or thermal diffusion, which function, for example, as source regions and/or drain regions of logic transistors 504. In some embodiments, isolation regions (e.g., STIs) are also formed in silicon substrate 502 by wet/dry etch and thin film deposition. A device layer 510 including a Flash memory controller (having logic transistors 504) and a peripheral circuit (having logic transistor 504) is thereby formed. Logic transistors 504 can be patterned and made in different regions of device layer 510 to form the Flash memory controller and the peripheral circuit.

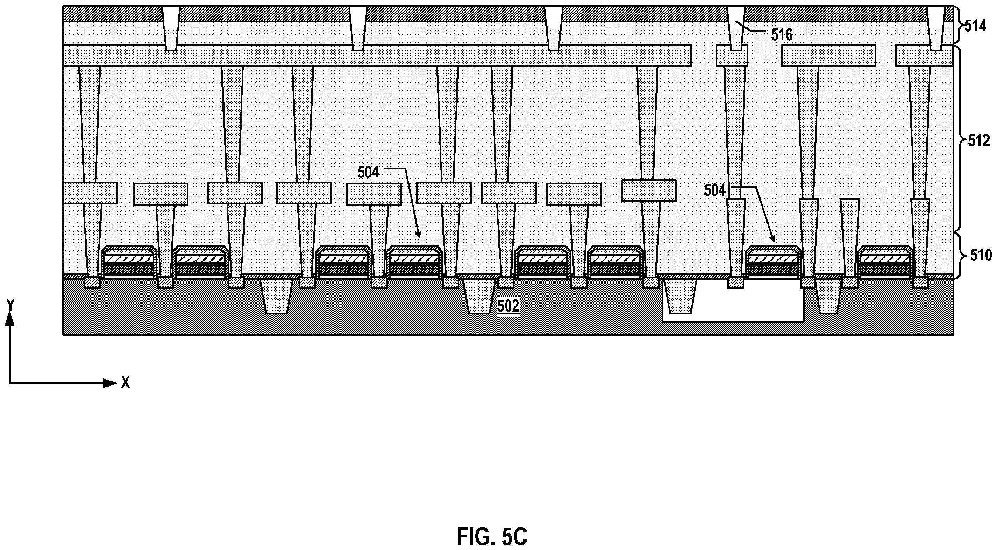

Method 1100 proceeds to operation 1104, as illustrated in FIG. 11A, in which a first interconnect layer is formed above the Flash memory controller and the peripheral circuit. The first interconnect layer can include a first plurality of interconnects in one or more ILD layers. As illustrated in FIG. 5B, an interconnect layer 512 is formed above device layer 510 including the Flash memory controller and peripheral circuit (each having logic transistors 504). Interconnect layer 512 can include interconnects of MEOL and/or BEOL in a plurality of ILD layers to make electrical connections with device layer 510. In some embodiments, interconnect layer 512 includes multiple ILD layers and interconnects therein formed in multiple processes. For example, the interconnects in interconnect layers 512 can include conductive materials deposited by one or more thin film deposition processes including, but not limited to, chemical vapor deposition (CVD), physical vapor deposition (PVD), atomic layer deposition (ALD), electroplating, electroless plating, or any combination thereof. Fabrication processes to form interconnects can also include photolithography, CMP, wet/dry etch, or any other suitable processes. The ILD layers can include dielectric materials deposited by one or more thin film deposition processes including, but not limited to, CVD, PVD, ALD, or any combination thereof. The ILD layers and interconnects illustrated in FIG. 5C can be collectively referred to as interconnect layer 512.

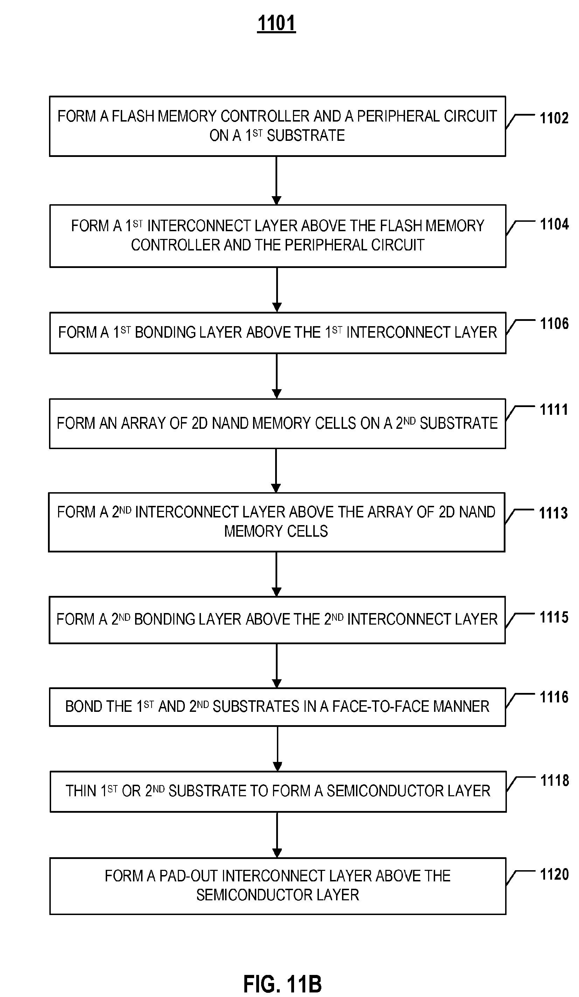

Method 1100 proceeds to operation 1106, as illustrated in FIG. 11, in which a first bonding layer is formed above the first interconnect layer. The first bonding layer includes a plurality of first bonding contacts. As illustrated in FIG. 5C, a bonding layer 514 is formed above interconnect layer 512. Bonding layer 514 includes a plurality of bonding contacts 516 surrounded by dielectrics. In some embodiments, a dielectric layer is deposited on the top surface of interconnect layer 512 by one or more thin film deposition processes including, but not limited to, CVD, PVD, ALD, or any combination thereof. Bonding contacts 516 then can be formed through the dielectric layer and in contact with the interconnects in interconnect layer 512 by first patterning contact holes through the dielectric layer using patterning process (e.g., photolithography and dry/wet etch of dielectric materials in the dielectric layer). The contact holes can be filled with a conductor (e.g., copper). In some embodiments, filling the contact holes includes depositing a barrier layer, an adhesion layer, and/or a seed layer before depositing the conductor.

Method 1100 proceeds to operation 1108, as illustrated in FIG. 11A, in which a memory stack is formed above a second substrate. The second substrate can be a silicon substrate. As illustrated in FIG. 6A, interleaved sacrificial layers (not shown) and dielectric layers 608 are formed above a silicon substrate 602. The interleaved sacrificial layers and dielectric layers 608 can form a dielectric stack (not shown). In some embodiments, each sacrificial layer includes a layer of silicon nitride, and each dielectric layer 608 includes a layer of silicon oxide. The interleaved sacrificial layers and dielectric layers 608 can be formed by one or more thin film deposition processes including, but not limited to, CVD, PVD, ALD, or any combination thereof. In some embodiments, a memory stack 604 can be formed by a gate replacement process, e.g., replacing the sacrificial layers with conductor layers 606 using wet/dry etch of the sacrificial layers selective to dielectric layers 608 and filling the resulting recesses with conductor layers 606. As a result, memory stack 604 can include interleaved conductor layers 606 and dielectric layers 608. In some embodiments, each conductor layer 606 includes a metal layer, such as a layer of tungsten. It is understood that memory stack 604 may be formed by alternatingly depositing conductor layers (e.g., doped polysilicon layers) and dielectric layers (e.g., silicon oxide layers) without the gate replacement process in other embodiments. In some embodiments, a pad oxide layer including silicon oxide is formed between memory stack 604 and silicon substrate 602.

Method 1100 proceeds to operation 1110, as illustrated in FIG. 11A, in which the array of 3D NAND memory strings extending vertically through the memory stack are formed. As illustrated in FIG. 6A, 3D NAND memory strings 610 are formed above silicon substrate 602, each of which extends vertically through interleaved conductor layers 606 and dielectric layers 608 of memory stack 604. In some embodiments, fabrication processes to form 3D NAND memory string 610 include forming a channel hole through memory stack 604 and into silicon substrate 602 using dry etching/and or wet etching, such as deep reactive-ion etching (DRIE), followed by epitaxially growing a plug 612 in the lower portion of the channel hole from silicon substrate 602. In some embodiments, fabrication processes to form 3D NAND memory string 610 also include subsequently filling the channel hole with a plurality of layers, such as a memory film 614 (e.g., a tunneling layer, a storage layer, and a blocking layer) and a semiconductor layer 616, using thin film deposition processes such as ALD, CVD, PVD, or any combination thereof. In some embodiments, fabrication processes to form 3D NAND memory string 610 further include forming another plug 618 in the upper portion of the channel hole by etching a recess at the upper end of 3D NAND memory string 610, followed by filling the recess with a semiconductor material using thin film deposition processes such as ALD, CVD, PVD, or any combination thereof.

Method 1100 proceeds to operation 1112, as illustrated in FIG. 11A, in which a second interconnect layer is formed above the array of 3D NAND memory strings. The second interconnect layer can include a second plurality of interconnects in one or more ILD layers. As illustrated in FIG. 6B, an interconnect layer 620 can be formed above memory stack 604 and array of 3D NAND memory strings 610. Interconnect layer 620 can include interconnects of MEOL and/or BEOL in a plurality of ILD layers to make electrical connections with 3D NAND memory strings 610. In some embodiments, interconnect layer 620 includes multiple ILD layers and interconnects therein formed in multiple processes. For example, the interconnects in interconnect layers 620 can include conductive materials deposited by one or more thin film deposition processes including, but not limited to, CVD, PVD, ALD, electroplating, electroless plating, or any combination thereof. Fabrication processes to form interconnects can also include photolithography, CMP, wet/dry etch, or any other suitable processes. The ILD layers can include dielectric materials deposited by one or more thin film deposition processes including, but not limited to, CVD, PVD, ALD, or any combination thereof. The ILD layers and interconnects illustrated in FIG. 6B can be collectively referred to as interconnect layer 620.

Method 1100 proceeds to operation 1114, as illustrated in FIG. 11A, in which a second bonding layer is formed above the second interconnect layer. The second bonding layer includes a plurality of second bonding contacts. As illustrated in FIG. 6B, a bonding layer 622 is formed above interconnect layer 620. Bonding layer 622 includes a plurality of bonding contacts 624 surrounded by dielectrics. In some embodiments, a dielectric layer is deposited on the top surface of interconnect layer 620 by one or more thin film deposition processes including, but not limited to, CVD, PVD, ALD, or any combination thereof. Bonding contacts 624 then can be formed through the dielectric layer and in contact with the interconnects in interconnect layer 620 by first patterning contact holes through the dielectric layer using patterning process (e.g., photolithography and dry/wet etch of dielectric materials in the dielectric layer). The contact holes can be filled with a conductor (e.g., copper). In some embodiments, filling the contact holes includes depositing a barrier layer, an adhesion layer, and/or a seed layer before depositing the conductor.

Method 1100 proceeds to operation 1116, as illustrated in FIG. 11A, in which the first substrate and the second substrate are bonded in a face-to-face manner, such that the first bonding contacts are in contact with the second bonding contacts at the bonding interface. The bonding is hybrid bonding. In some embodiments, the first substrate on which the Flash memory controller and the peripheral circuit are formed (e.g., the first semiconductor structure) is disposed above the second substrate on which the 3D NAND memory strings are formed (e.g., the second semiconductor structure) after the bonding. In some embodiments, the second substrate on which the 3D NAND memory strings are formed (e.g., the second semiconductor structure) is disposed above the first substrate on which the Flash memory controller and the peripheral circuit are formed (e.g., the first semiconductor structure) after the bonding.

As illustrated in FIG. 7A, silicon substrate 602 and components formed thereon (e.g., 3D NAND memory strings 610) are flipped upside down. Bonding layer 622 facing down is bonded with bonding layer 514 facing up, i.e., in a face-to-face manner, thereby forming a bonding interface 702 (as shown in FIG. 7B). In some embodiments, a treatment process, e.g., a plasma treatment, a wet treatment, and/or a thermal treatment, is applied to the bonding surfaces prior to the bonding. Although not shown in FIG. 7A, silicon substrate 502 and components formed thereon (e.g., device layer 510) can be flipped upside down, and bonding layer 514 facing down can be bonded with bonding layer 622 facing up, i.e., in a face-to-face manner, thereby forming bonding interface 702. After the bonding, bonding contacts 624 in bonding layer 622 and bonding contacts 516 in bonding layer 514 are aligned and in contact with one another, such that device layer 510 (e.g., the Flash memory controller and peripheral circuit therein) can be electrically connected to 3D NAND memory strings 610. It is understood that in the bonded chip, 3D NAND memory strings 610 may be either above or below device layer 510 (e.g., the Flash memory controller and peripheral circuit therein). Nevertheless, bonding interface 702 can be formed between 3D NAND memory strings 610 and device layer 510 (e.g., the Flash memory controller and peripheral circuit therein) after the bonding as illustrated in FIG. 7B.

Method 1100 proceeds to operation 1118, as illustrated in FIG. 11A, in which the first substrate or the second substrate is thinned to form a semiconductor layer. In some embodiments, the first substrate of the first semiconductor structure, which is above the second substrate of the second semiconductor structure after the bonding, is thinned to form the semiconductor layer. In some embodiments, the second substrate of the second semiconductor structure, which is above the first substrate of the first semiconductor structure after the bonding, is thinned to form the semiconductor layer.

As illustrated in FIG. 7B, the substrate at the top of the bonded chip (e.g., silicon substrate 602 as shown in FIG. 7A) is thinned, so that the thinned top substrate can serve as a semiconductor layer 704, for example, a single-crystal silicon layer. The thickness of the thinned substrate can be between about 200 nm and about 5 µm, such as between 200 nm and 5 µm, or between about 150 nm and about 50 µm, such as between 150 nm and 50 µm. Silicon substrate 602 can be thinned by processes including, but not limited to, wafer grinding, dry etch, wet etch, CMP, any other suitable processes, or any combination thereof. It is understood that when silicon substrate 502 is the substrate at the top of the bonded chip, another semiconductor layer may be formed by thinning silicon substrate 502.

Method 1100 proceeds to operation 1120, as illustrated in FIG. 11A, in which a pad-out interconnect layer is formed above the semiconductor layer. As illustrated in FIG. 7B, a pad-out interconnect layer 706 is formed above semiconductor layer 704 (the thinned top substrate). Pad-out interconnect layer 706 can include interconnects, such as pad contacts 708, formed in one or more ILD layers. Pad contacts 708 can include conductive materials including, but not limited to, W, Co, Cu, Al, doped silicon, silicides, or any combination thereof. The ILD layers can include dielectric materials including, but not limited to, silicon oxide, silicon nitride, silicon oxynitride, low-k dielectrics, or any combination thereof. In some embodiments, after the bonding and thinning, contacts 710 are formed extending vertically through semiconductor layer 704, for example, by wet/dry etch followed by depositing conductive materials. Contacts 710 can be in contact with the interconnects in pad-out interconnect layer 706.

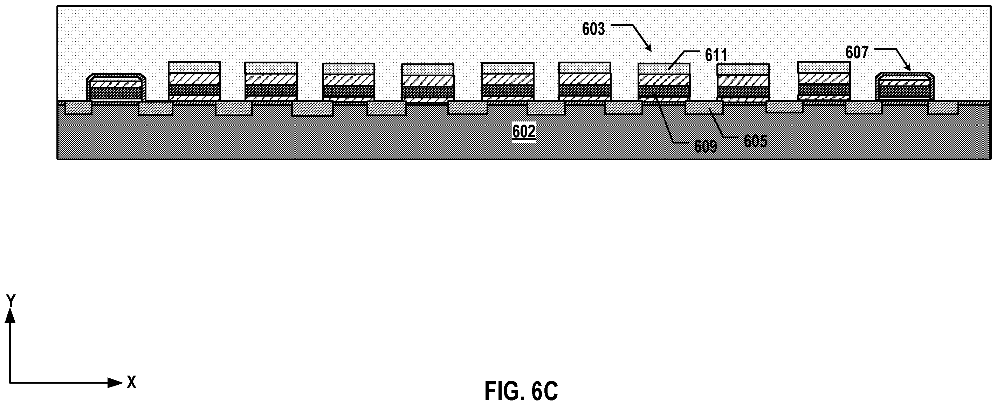

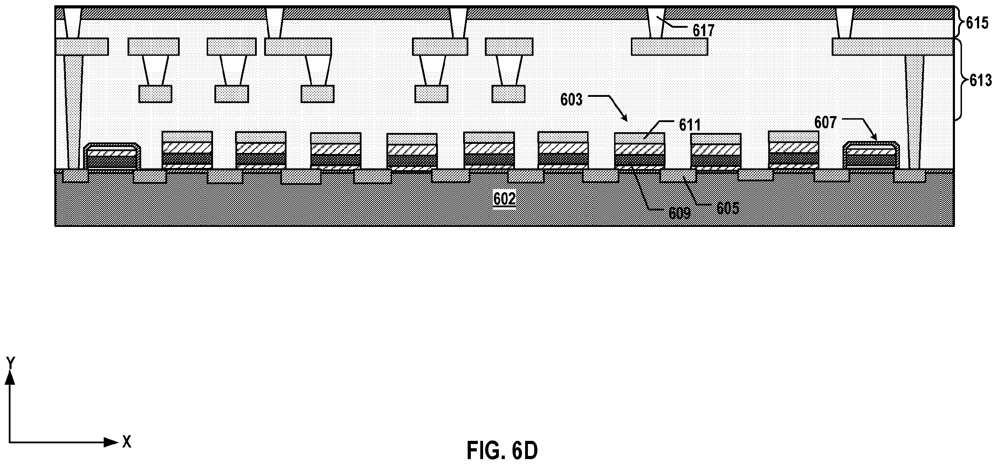

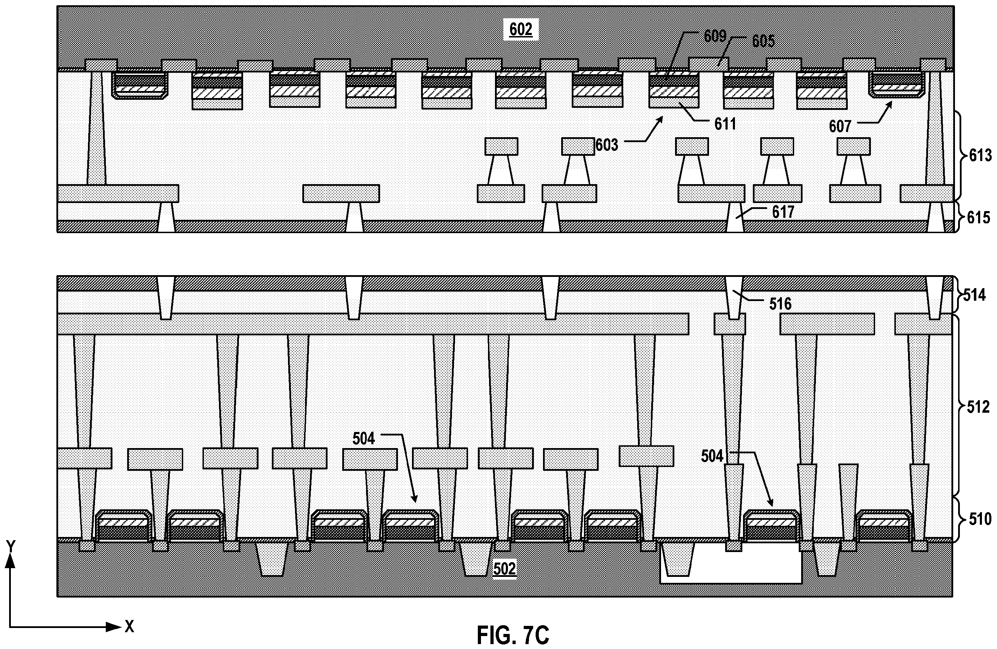

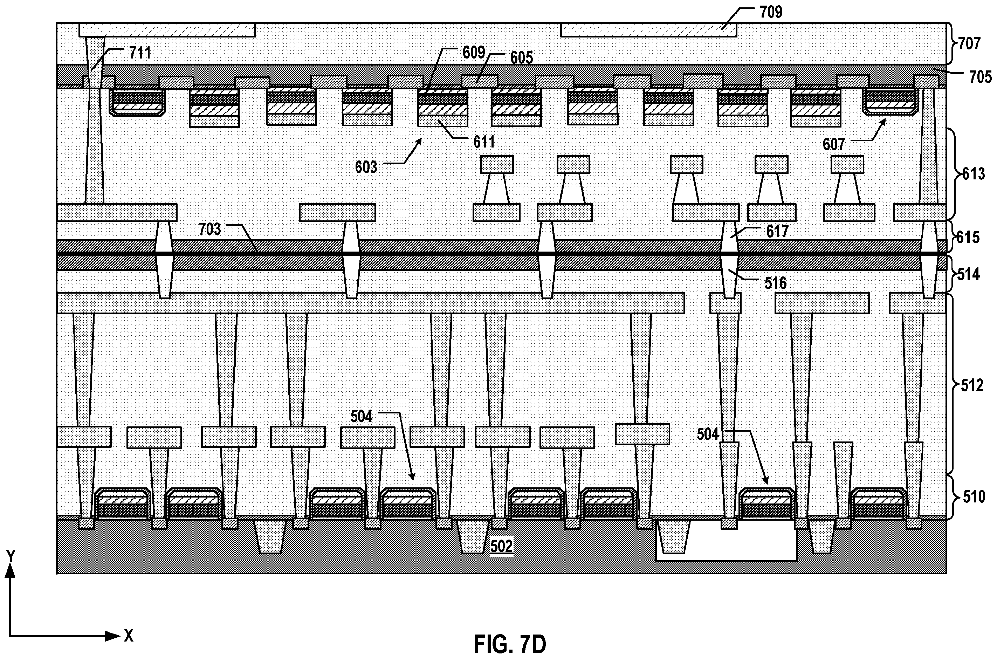

As described above, 2D NAND memory cells, instead of 3D NAND memory strings, may be formed on a separate substrate and bonded into the memory device. FIGs. 6C and 6D illustrate a fabrication process for forming an exemplary semiconductor structure having 2D NAND memory cells, according to some embodiments. FIGs. 7C and 7D illustrate a fabrication process for forming another exemplary memory device, according to some embodiments. FIG. 11B is a flowchart of another exemplary method 1101 for forming a memory device, according to some embodiments. Examples of the memory device depicted in FIGs. 6C, 6D, 7C, 7D, and 11B include memory device 301 depicted in FIG. 3B and memory device 401 depicted in FIG. 4B. FIGs. 6C, 6D, 7C, 7D, and 11B will be described together. It is understood that the operations shown in method 1101 are not exhaustive and that other operations can be performed as well before, after, or between any of the illustrated operations. Further, some of the operations may be performed simultaneously, or in a different order than shown in FIG. 11B.

Operations 1102, 1104, and 1106 of method 1101 in FIG. 11B are described above with respect to method 1100 in FIG. 11A and thus, are not repeated. Method 1101 proceeds to operation 1111, as illustrated in FIG. 11B, in which an array of 2D NAND memory cells are formed on a second substrate. As illustrated in FIG. 6C, 2D NAND memory cells 603 are formed on silicon substrate 602 in the form of 2D NAND memory strings, each of which includes a plurality of memory cells connected in series by sources/drains 605 (resembling a NAND gate) and two select transistors 607 at the ends of the 2D NAND memory string, respectively. 2D NAND memory cells 603 and select transistors 607 can be formed by a plurality of processes including, but not limited to, photolithography, dry/wet etch, thin film deposition, thermal growth, implantation, CMP, and any other suitable processes. In some embodiments, doped regions are formed in silicon substrate 602 by ion implantation and/or thermal diffusion, which function, for example, as sources/drains 605. In some embodiments, isolation regions (e.g., STIs, not shown) are also formed in silicon substrate 602 by wet/dry etch and thin film deposition.

In some embodiments, a gate stack is formed for each 2D NAND memory cell 603. The gate stack can include a tunneling layer, a floating gate 609, a blocking layer, and a control gate 611 from bottom to top in this order for "floating gate" type of 2D NAND memory cells 603. In some embodiments, floating gate 609 is replaced by a storage layer for "charge trap" type of 2D NAND memory cells. The tunneling layer, floating gate 609 (or storage layer), blocking layer, and control gate 611 of the gate stack can be formed by one or more thin film deposition processes including, but not limited to, CVD, PVD, ALD, electroplating, electroless plating, or any combination thereof.

Method 1100 proceeds to operation 1113, as illustrated in FIG. 11B, in which a second interconnect layer is formed above the array of 2D NAND memory cells. The second interconnect layer can include a second plurality of interconnects in one or more ILD layers. As illustrated in FIG. 6D, an interconnect layer 613 can be formed above array of 2D NAND memory cells 603. Interconnect layer 613 can include interconnects of MEOL and/or BEOL in a plurality of ILD layers to make electrical connections with 2D NAND memory cells 603. In some embodiments, interconnect layer 613 includes multiple ILD layers and interconnects therein formed in multiple processes. For example, the interconnects in interconnect layers 613 can include conductive materials deposited by one or more thin film deposition processes including, but not limited to, CVD, PVD, ALD, electroplating, electroless plating, or any combination thereof. The ILD layers can include dielectric materials deposited by one or more thin film deposition processes including, but not limited to, CVD, PVD, ALD, or any combination thereof. The ILD layers and interconnects illustrated in FIG. 6D can be collectively referred to as interconnect layer 613.

Method 1100 proceeds to operation 1115, as illustrated in FIG. 11B, in which a second bonding layer is formed above the second interconnect layer. The second bonding layer can include a plurality of second bonding contacts. As illustrated in FIG. 6D, a bonding layer 615 is formed above interconnect layer 613. Bonding layer 615 includes a plurality of bonding contacts 617 surrounded by dielectrics. In some embodiments, a dielectric layer is deposited on the top surface of interconnect layer 613 by one or more thin film deposition processes including, but not limited to, CVD, PVD, ALD, or any combination thereof. Bonding contacts 617 then can be formed through the dielectric layer and in contact with the interconnects in interconnect layer 613 by first patterning contact holes through the dielectric layer using patterning process (e.g., photolithography and dry/wet etch of dielectric materials in the dielectric layer). The contact holes can be filled with a conductor (e.g., copper). In some embodiments, filling the contact holes includes depositing a barrier layer, an adhesion layer, and/or a seed layer before depositing the conductor.

Operations 1116, 1118, and 1120 of method 1101 in FIG. 11B are described above with respect to method 1100 in FIG. 11A and thus, are not repeated. As illustrated in FIG. 7C, silicon substrate 602 and components formed thereon (e.g., 2D NAND memory cells 603) are flipped upside down. Bonding layer 615 facing down is bonded with bonding layer 514 facing up, i.e., in a face-to-face manner, thereby forming a bonding interface 703 (as shown in FIG. 7D). Although not shown in FIG. 7C, silicon substrate 502 and components formed thereon (e.g., device layer 510) can be flipped upside down, and bonding layer 514 facing down can be bonded with bonding layer 615 facing up, i.e., in a face-to-face manner, thereby forming bonding interface 702. After the bonding, bonding contacts 617 in bonding layer 615 and bonding contacts 516 in bonding layer 514 are aligned and in contact with one another, such that device layer 510 (e.g., the Flash memory controller and peripheral circuit therein) can be electrically connected to 2D NAND memory cells 603. It is understood that in the bonded chip, 2D NAND memory cells 603 may be either above or below device layer 510 (e.g., the Flash memory controller and peripheral circuit therein).

As illustrated in FIG. 7D, the substrate at the top of the bonded chip (e.g., silicon substrate 602 as shown in FIG. 7C) is thinned, so that the thinned top substrate can serve as a semiconductor layer 705, for example, a single-crystal silicon layer. Silicon substrate 602 can be thinned by processes including, but not limited to, wafer grinding, dry etch, wet etch, CMP, any other suitable processes, or any combination thereof. It is understood that when silicon substrate 502 is the substrate at the top of the bonded chip, another semiconductor layer may be formed by thinning silicon substrate 502. As illustrated in FIG. 7D, a pad-out interconnect layer 707 is formed above semiconductor layer 705 (the thinned top substrate). Pad-out interconnect layer 707 can include interconnects, such as pad contacts 709, formed in one or more ILD layers. In some embodiments, after the bonding and thinning, contacts 711 are formed extending vertically through semiconductor layer 705, for example by wet/dry etch followed by depositing conductive materials. Contacts 711 can be in contact with the interconnects in pad-out interconnect layer 707.

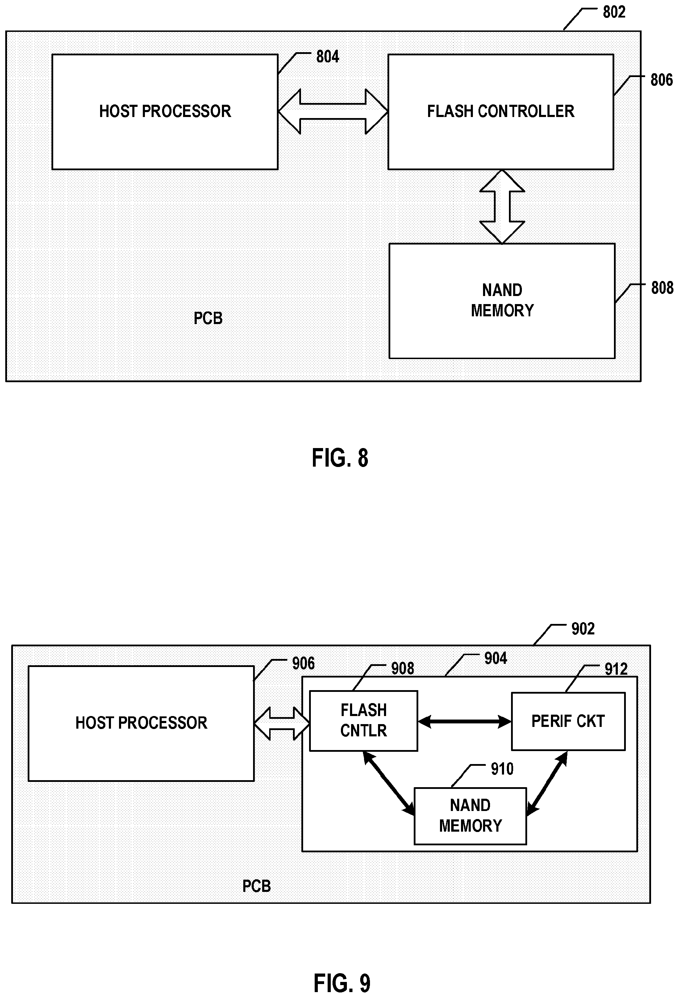

As described above, in existing NAND Flash memory, the Flash memory controller and memory (e.g., NAND memory chip) are placed on the PCB as discrete chips, which communicate with each other through relatively long and slow interlinks (e.g., various data buses) on the PCB, thereby suffering from relatively low data throughput. Moreover, the large number of discrete chips occupy large PCB area. Conventionally, FIG. 8 illustrates a schematic diagram of a discrete host processor 804, a Flash memory controller 806, and NAND memory 808 on a PCB 802 and operations thereof. Each one of host processor 804, Flash memory controller 806, and NAND memory 808 is a discrete chip with its own package and mounted on PCB 802. Host processor 804 is a specialized processor, such as a central processing unit (CPU), or a system-on-chip (SoC), such as an application processor. Data is transmitted between host processor 804 and Flash memory controller 806 through an interlink, such as a processor bus. NAND memory 808 is a 3D NAND memory or a 2D NAND memory, which transfers data with Flash memory controller 806 through another interlink.

In another conventional example (not shown), the chips of Flash memory controller 806 and NAND memory 808 may be included in the same package, such as a universal Flash storage (UFS) package or an eMMC package, and electrically connected through wire bonding. Flash memory controller 806 then may transfer data with host processor 804 through an interlink, such as a processor bus, which is driven by a software driver, such as a UFS driver software or an MMC driver software.

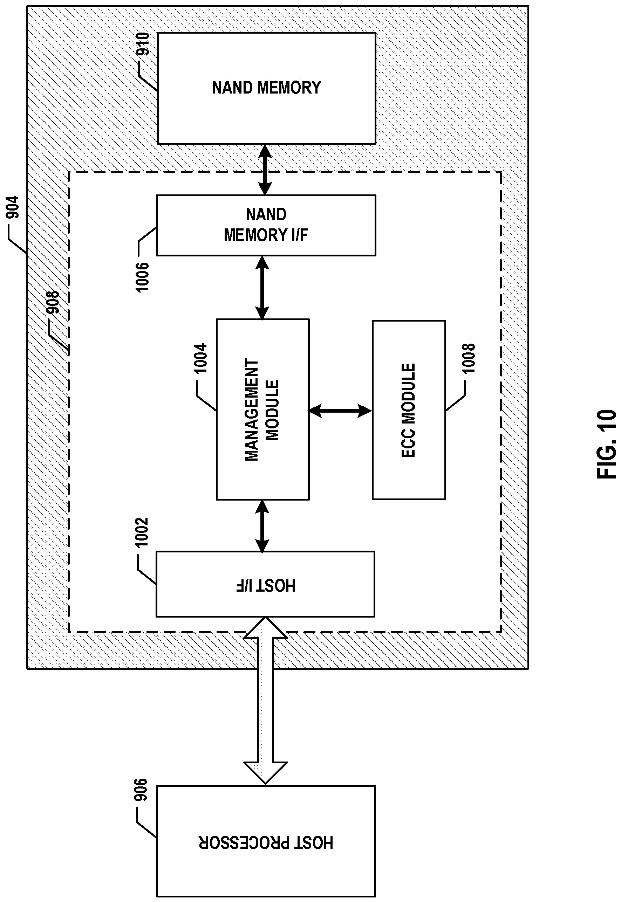

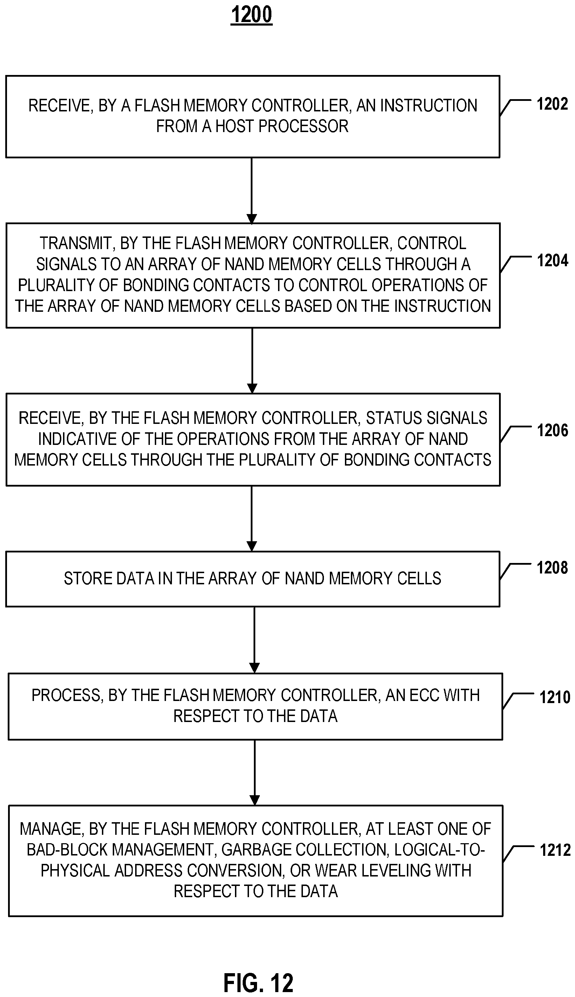

FIG. 9 illustrates a schematic diagram of an exemplary memory device 904 having a Flash memory controller 908 on a PCB 902 and operations thereof, in accordance with the claimed invention. FIG. 10 illustrates a detailed schematic diagram of one example of Flash memory controller 908 in FIG. 9, according to some embodiments. FIG. 12 is a flowchart of an exemplary method 1200 for operating a memory device, according to some embodiments. Examples of the memory device depicted in FIG. 12 include memory device 904 depicted in FIGs. 9 and 10. FIGs. 9, 10, and 12 will be described together. It is understood that the operations shown in method 1200 are not exhaustive and that other operations can be performed as well before, after, or between any of the illustrated operations. Further, some of the operations may be performed simultaneously, or in a different order than shown in FIG. 12. As illustrated in FIG. 9, memory device 904 includes Flash memory controller 908, NAND memory 910 having an array of NAND memory cells, and a peripheral circuit 912 of NAND memory 910. Flash memory controller 908, NAND memory 910 (either a 3D NAND memory or a 2D NAND memory), and peripheral circuit 912 can be formed in the same bonded chip as described above in detail, such as memory device 100, 101, 300, 301, 400, and 401.

Referring to FIG. 12, method 1200 starts at operation 1202, in which an instruction is received by a Flash memory controller from a host processor. As illustrated in FIG. 9, any suitable type of instruction generated by host processor 906 can be transferred to flash memory controller 908 of memory device 904, for example, instructions for performing the read/ write/ erase or program operations on NAND memory 910. As illustrated in FIG. 10, Flash memory controller 908 includes a host interface (I/F) 1002 operatively coupled to host processor 906, for example, through a processor bus, and configured to receive the instruction from host processor 906. Host I/F 1002 can include a serial attached SCSI (SAS), parallel SCSI, PCI express (PCIe), NVM express (NVMe), advanced host controller interface (AHCI), to name a few.

Method 1200 proceeds to operation 1204, as illustrated in FIG. 12, in which control signals are transmitted by the Flash memory controller to an array of NAND memory cells through a plurality of bonding contacts to control operations of the array of NAND memory cells based on the instruction. Method 1200 proceeds to operation 1206, as illustrated in FIG. 12, in which status signals indicative of the operations from the array of NAND memory cells are received by the Flash memory controller through the plurality of bonding contacts.

As illustrated in FIG. 9, electrical signals (including data, control signals, and status signals) can be bidirectionally transferred between Flash memory controller 908 and NAND memory 910 through direct electrical connections by a plurality of bonding contacts (e.g., over millions of bonding contacts in parallel) as described above in detail, which have shortened distance, higher throughput, and lower power consumption compared with the conventional on-board chip-to-chip data bus, for example, shown in FIG. 8. Similarly, electrical signals (including data, control signals, and status signals) can be bidirectionally transferred between peripheral circuit 912 and NAND memory 910 through direct electrical connections by the plurality of bonding contacts (e.g., over millions of bonding contacts in parallel). As illustrated in FIG. 9, bidirectional transfer of electrical signals can be achieved between Flash memory controller 908 and peripheral circuit 912 as well through direct electrical connections by interconnects in the same chip.

As illustrated in FIG. 10, Flash memory controller 908 also includes a management module 1004 and a NAND memory interface (I/F) 1006. In some embodiments, management module 1004 is operatively coupled to host I/F 1002 and NAND memory I/F 1006 and configured to generate one or more control signals to control operations (e.g., read, write, erase, and program operations) of NAND memory 910 based on the instruction received from host processor 906 and send the control signals to NAND memory I/F 1006. Management module 1004 can be any suitable control and state machine. In some embodiments, NAND memory I/F 1006 is configured to transmit the control signals to NAND memory 910 and receive the status signals from NAND memory 910. The status signal can indicate the status of each operation performed by NAND memory 910 (e.g., failure, success, delay, etc.), which can be sent back to management module 1004 as feedbacks. NAND memory I/F 1006 can include single data rate (SDR) NAND Flash interface, open NAND Flash interface (ONFI), Toggle double data rate (DDR) interface, to name a few.

Method 1200 proceeds to operation 1208, as illustrated in FIG. 12, in which data is stored in the array of NAND memory cells. As illustrated in FIG. 9, data from host processor 906 can be stored in NAND memory 910 as controlled by Flash memory controller 908, for example, by the write operations.

Method 1200 proceeds to operation 1210, as illustrated in FIG. 12, in which the an ECC with respect to the data is processed by the Flash memory controller. As illustrated in FIG. 10, Flash memory controller 908 further includes an ECC module 1008 operatively coupled to management module 1004 and configured to process the ECC. The data written into or read from NAND memory 910 can be encoded or decoded based on an ECC to reduce errors in the data. ECC can add redundancy to the transmitted data using an algorithm including, for example, Hamming code, Bose-Chaudhuri-Hocquenghem (BCH) code, and Reed-Solomon code.

Method 1200 proceeds to operation 1212, as illustrated in FIG. 12, in which at least one of bad-block management, garbage collection, logical-to-physical address conversion, or wear leveling with respect to the data is managed by the Flash memory controller. As illustrated in FIG. 10, management module 1004 of Flash memory controller 908 can be further configured to perform any suitable management functions with respect to the data written into or read from NAND memory 910 to reduce the burden on host processor 906. The management functions include, but not limited to, bad-block management, garbage collection, logical-to-physical address conversion, and wear leveling.

According to one aspect of the present disclosure, a memory device includes a first semiconductor structure including a Flash memory controller, a peripheral circuit, and a first bonding layer including a plurality of first bonding contacts. The memory device also includes a second semiconductor structure including an array of NAND memory cells and a second bonding layer including a plurality of second bonding contacts. The memory device further includes a bonding interface between the first bonding layer and the second bonding layer. The first bonding contacts are in contact with the second bonding contacts at the bonding interface.

In some embodiments, the first semiconductor structure includes a substrate, the Flash memory controller on the substrate, the peripheral circuit on the substrate and outside of the Flash memory controller, and the first bonding layer above the Flash memory controller and the peripheral circuit.

In some embodiments, the second semiconductor structure includes the second bonding layer above the first bonding layer, a memory stack above the second bonding layer, an array of 3D NAND memory strings extending vertically through the memory stack, and a semiconductor layer above and in contact with the array of 3D NAND memory strings.

In some embodiments, the second semiconductor structure includes the second bonding layer above the first bonding layer, an array of 2D NAND memory cells above the second bonding layer, and a semiconductor layer above and in contact with the array of 2D NAND memory cells.

In some embodiments, the 3D memory device further includes a pad-out interconnect layer above the semiconductor layer. In some embodiments, the semiconductor layer includes polysilicon. In some embodiments, the semiconductor layer includes single-crystal silicon.

In some embodiments, the second semiconductor structure includes a substrate, a memory stack above the substrate, an array of 3D NAND memory strings extending vertically through the memory stack, and the second bonding layer above the memory stack and the array of 3D NAND memory strings.

In some embodiments, the second semiconductor structure includes a substrate, an array of 2D NAND memory cells on the substrate, and the second bonding layer above the memory stack and the array of 2D NAND memory cells.

In some embodiments, the first semiconductor structure includes the first bonding layer above the second bonding layer, the Flash memory controller above the first bonding layer, the peripheral circuit above the first bonding layer and outside of the Flash memory controller, and a semiconductor layer above and in contact with the Flash memory controller and the peripheral circuit. In some embodiments, the memory device further includes a pad-out interconnect layer above the semiconductor layer.

In accordance with the claimed invention, the Flash memory controller and the peripheral circuit are stacked one over another.

According to the invention, the peripheral circuit includes one or more page buffers and word line drivers of the array of NAND memory cells.

According to the invention, the first semiconductor structure includes a first interconnect layer vertically between the first bonding layer and the Flash memory controller, and the second semiconductor structure includes a second interconnect layer vertically between the second bonding layer and the array of NAND memory cells.

In some embodiments, the Flash memory controller is electrically connected to the array of NAND memory cells through the first and second interconnect layers and the first and second bonding contacts.

According to the invention, the peripheral circuit is electrically connected to the array of NAND memory cells through the first and second interconnect layers and the first and second bonding contacts.

According to the invention, the peripheral circuit is electrically connected to the Flash memory controller through the first interconnect layer.

According to the invention, the Flash memory controller includes a host interface operatively coupled to a host processor, a NAND memory interface operatively coupled to the array of NAND memory cells, a management module, and an ECC module. In some embodiments, the ECC module is configured to process an ECC, and the management module is configured to manage at least one of bad-block management, garbage collection, logical-to-physical address conversion, or wear leveling.

According to another aspect of the present disclosure, a method for forming a memory device is disclosed. A first semiconductor structure is formed. The first semiconductor structure includes a Flash memory controller, a peripheral circuit, and a first bonding layer including a plurality of first bonding contacts. A second semiconductor structure is formed. The second semiconductor structure includes an array of NAND memory cells and a second bonding layer including a plurality of second bonding contacts. The first semiconductor structure and the second semiconductor structure are bonded in a face-to-face manner, such that the first bonding contacts are in contact with the second bonding contacts at a bonding interface.

According to the invention, to form the first semiconductor structure, the Flash memory controller and the peripheral circuit are formed on a first substrate, a first interconnect layer is formed above the Flash memory controller and the peripheral circuit, and the first bonding layer is formed above the first interconnect layer.

In some embodiments, to form the Flash memory controller and the peripheral circuit, a plurality of transistors are formed on the first substrate.

In some embodiments, to form the second semiconductor structure, a memory stack is formed above a second substrate, an array of 3D NAND memory strings extending vertically through the memory stack are formed, a second interconnect layer is formed above the array of 3D NAND memory strings, and the second bonding layer is formed above the second interconnect layer.

In some embodiments, to form the second semiconductor structure, an array of 2D NAND memory cells are formed on a second substrate, a second interconnect layer is formed above the array of 2D NAND memory cells, and the second bonding layer is formed above the second interconnect layer.

In some embodiments, the second semiconductor structure is above the first semiconductor structure after the bonding. In some embodiments, the second substrate is thinned to form a semiconductor layer after the bonding, and a pad-out interconnect layer is formed above the semiconductor layer.

In some embodiments, the first semiconductor structure is above the second semiconductor structure after the bonding. In some embodiments, the first substrate is thinned to form a semiconductor layer after the bonding, and a pad-out interconnect layer is formed above the semiconductor layer.

In some embodiments, the bonding includes hybrid bonding.

According to the invention, the peripheral circuit includes one or more page buffers and word line drivers of the array of NAND memory cells.

According to the invention, the Flash memory controller includes a host interface operatively coupled to a host processor, a NAND memory interface operatively coupled to the array of NAND memory cells, a management module, and an ECC module.

According to still another aspect of the present disclosure, a method for operating a memory device is disclosed. The memory device includes a Flash memory controller, a peripheral circuit, and an array of NAND memory cells in a same bonded chip. An instruction from a host processor is received by the Flash memory controller. Control signals are transmitted by the Flash memory controller to the array of NAND memory cells through a plurality of bonding contacts to control operations of the array of NAND memory cells based on the instruction. Status signals indicative of the operations are received by the Flash memory controller from the array of NAND memory cells through the plurality of bonding contacts.

In some embodiments, data is transferred between the peripheral circuit and the array of NAND memory cells through the plurality of bonding contacts.

In some embodiments, the data is stored in the array of NAND memory cells.

In some embodiments, an ECC with respect to the data is processed by the Flash memory controller, and at least one of bad-block management, garbage collection, logical-to-physical address conversion, or wear leveling with respect to the data is managed by the Flash memory controller.

The Summary section may set forth one or more but not all exemplary embodiments of the present disclosure as contemplated by the inventor(s), and thus, is not intended to limit the present disclosure and the appended claims in any way.

The scope of the present disclosure should not be limited by any of the above-described exemplary embodiments, but should be defined only in accordance with the following claims.

## Claims

1. A memory device (300), comprising:
a first semiconductor structure (302) comprising a Flash memory controller (312), a peripheral circuit (314), and a first bonding layer (324) comprising a plurality of first bonding contacts (326);
a second semiconductor structure (304) comprising an array of NAND memory cells (337, 416) and a second bonding layer (328) comprising a plurality of second bonding contacts (330);
wherein the peripheral circuit comprises one or more page buffers (204) and word line drivers (202) of the array of NAND memory cells, and wherein the Flash memory controller comprises a host interface (1002) operatively coupled to a host processor (906), a NAND memory interface (1006) operatively coupled to the array of NAND memory cells, a management module (1004), and an error correction code, ECC, module (1008);
wherein the first semiconductor structure comprises a first interconnect layer (322) vertically between the first bonding layer and the Flash memory controller, and the second semiconductor structure comprises a second interconnect layer (332) vertically between the second bonding layer and the array of NAND memory cells; and
a bonding interface (306) between the first bonding layer and the second bonding layer, wherein the first bonding contacts are in contact with the second bonding contacts at the bonding interface, and wherein the bonding interface between the first bonding layer and the second bonding layer is as a result of hybrid bonding that obtains metal-metal bonding and dielectric-dielectric bonding simultaneously;
wherein the peripheral circuit is electrically connected to the Flash memory controller through the first interconnect layer; and
wherein the peripheral circuit is electrically connected to the array of NAND memory cells through the first and second interconnect layers and the first and second bonding contacts,
**characterised in that**
the Flash memory controller and the peripheral circuit are stacked one over another.

2. The memory device of claim 1, wherein the first semiconductor structure (302) comprises:
a substrate (308);
the Flash memory controller (312) on the substrate;
the peripheral circuit (314) on the substrate and outside of the Flash memory controller; and
the first bonding layer above the Flash memory controller and the peripheral circuit.

3. The memory device of claim 2, wherein the second semiconductor structure (304) comprises:
the second bonding layer (328) above the first bonding layer (324);
a memory stack (333) above the second bonding layer;
an array of three-dimensional, 3D, NAND memory strings (338) extending vertically through the memory stack; and
a semiconductor layer (348) above and in contact with the array of 3D NAND memory strings.

4. The memory device of claim 2, wherein the second semiconductor structure (304) comprises:
the second bonding layer (328) above the first bonding layer (324);
an array of two-dimensional, 2D, NAND memory cells (337) above the second bonding layer; and
a semiconductor layer (347) above and in contact with the array of 2D NAND memory cells.

5. The memory device of claim 4, wherein the second semiconductor structure (304) comprises:
a pad-out interconnect layer (349) above the semiconductor layer (347).

6. The memory device of claim 3, wherein the semiconductor layer (348) comprises
- polysilicon;
or
- single-crystal silicon.

7. The memory device of claim 1, wherein the second semiconductor structure (304) comprises:
a substrate (348);
a memory stack (333) above the substrate;
an array of 3D NAND memory strings (338) extending vertically through the memory stack; and
the second bonding layer (328) above the memory stack and the array of 3D NAND memory strings.

8. The memory device of claim 1, wherein the second semiconductor structure (304) comprises:
a substrate (347);
an array of 2D NAND memory cells (337) on the substrate; and
the second bonding layer (328) above the array of 2D NAND memory cells.

9. The memory device of claim 1, wherein
the ECC module (1008) is configured to process an ECC; and
the management module (1004) is configured to manage at least one of bad-block management, garbage collection, logical-to-physical address conversion, or wear leveling.

10. A method for forming a memory device (300), comprising:
forming a first semiconductor structure (302) comprising a Flash memory controller (312), a peripheral circuit (314), and a first bonding layer (324) comprising a plurality of first bonding contacts (326);
forming a second semiconductor structure (304) comprising an array of NAND memory cells (337, 416) and a second bonding layer (328) comprising a plurality of second bonding contacts (330);
wherein the peripheral circuit comprises one or more page buffers (204) and word line drivers (202) of the array of NAND memory cells, and wherein the Flash memory controller comprises a host interface (1002) operatively coupled to a host processor (906), a NAND memory interface (1006) operatively coupled to the array of NAND memory cells, a management module (1004), and an error correction code, ECC, module (1008);
wherein the first semiconductor structure comprises a first interconnect layer (322) vertically between the first bonding layer and the Flash memory controller, and the second semiconductor structure comprises a second interconnect layer (332) vertically between the second bonding layer and the array of NAND memory cells; and
bonding the first semiconductor structure and the second semiconductor structure in a face-to-face manner, such that the first bonding contacts are in contact with the second bonding contacts at a bonding interface (306), and wherein the bonding interface between the first bonding layer and the second bonding layer is as a result of hybrid bonding that obtains metal-metal bonding and dielectric-dielectric bonding simultaneously;
wherein the peripheral circuit is electrically connected to the Flash memory controller through the first interconnect layer;
wherein the peripheral circuit is electrically connected to the array of NAND memory cells through the first and second interconnect layers and the first and second bonding contacts; and
**characterised in that**
the Flash memory controller and the peripheral circuit are stacked one over another.

11. The method of claim 10, wherein
forming the Flash memory controller (312) and the peripheral circuit (314) comprises forming a plurality of transistors (316) on a first substrate (308) of the first semiconductor structure (302).

12. The method of any one of claims 10 to 11, wherein forming the second semiconductor structure (304) comprises:
forming a memory stack (333) above a second substrate (602);
forming an array of three-dimensional, 3D, NAND memory strings (338) extending vertically through the memory stack;
forming the second interconnect layer (332) above the array of 3D NAND memory strings; and
forming the second bonding layer (328) above the second interconnect layer; or
- forming an array of two-dimensional, 2D, NAND memory cells (337) on a second substrate (602);
forming the second interconnect layer above the array of 2D NAND memory cells; and
forming the second bonding layer above the second interconnect layer.

13. The method of any one of claims 10 to 12, wherein the second semiconductor structure (304) is above the first semiconductor structure (302) after the bonding, preferably comprising:
thinning the second substrate (602) to form a semiconductor layer (347, 348) after the bonding; and
forming a pad-out interconnect layer (349, 350) above the semiconductor layer.

14. A method of operating the memory device of any of claims 1 to 9, the method comprising:
receiving, by the Flash memory controller (312), an instruction from a host processor (906);
transmitting, by the Flash memory controller, control signals to the array of NAND memory cells (337, 416) through the plurality of bonding contacts (326, 330) to control operations of the array of NAND memory cells based on the instruction; and
receiving, by the Flash memory controller, status signals indicative of the operations from the array of NAND memory cells through the plurality of bonding contacts, preferably comprising:
transferring data between the peripheral circuit (314) and the array of NAND memory cells through the plurality of bonding contacts.

15. The method of claim 14, further comprising storing the data in the array of NAND memory cells (337, 416) preferably comprising:
processing, by the Flash memory controller (312), an error correction code, ECC, with respect to the data; and managing, by the Flash memory controller, at least one of bad-block management, garbage collection, logical-to-physical address conversion, or wear leveling with respect to the data.

## Patentansprüche

1. Speichervorrichtung (300), umfassend:
eine erste Halbleiterstruktur (302) mit einem Flash-Speicher-Controller (312), einer Peripherieschaltung (314) und einer ersten Bonding-Schicht (324) mit einer Mehrzahl von ersten Bonding-Kontakten (326);
eine zweite Halbleiterstruktur (304) mit einem Array von NAND-Speicherzellen (337, 416) und einer zweiten Bonding-Schicht (328) mit einer Mehrzahl von zweiten Bonding-Kontakten (330);
wobei die Peripherieschaltung einen oder mehrere Seitenpuffer (204) und Wortleitungstreiber (202) des Array von NAND-Speicherzellen aufweist und wobei der Flash-Speicher-Controller eine Host-Schnittstelle (1002) aufweist, die mit einem Hostprozessor (906) wirkverbunden ist, eine NAND-Speicherschnittstelle (1006), die mit dem Array von NAND-Speicherzellen wirkverbunden ist, ein Managementmodul (1004) und ein Fehlerkorrekturcode(ECC)-Modul (1008);
wobei die erste Halbleiterstruktur eine erste Verbindungsschicht (322) vertikal zwischen der ersten Bonding-Schicht und dem Flash-Speicher-Controller aufweist und die zweite Halbleiterstruktur eine zweite Verbindungsschicht (332) vertikal zwischen der zweiten Bonding-Schicht und dem Array von NAND-Speicherzellen aufweist; und
eine Bonding-Schnittstelle (306) zwischen der ersten Bonding-Schicht und der zweiten Bonding-Schicht, wobei sich die ersten Bonding-Kontakte an der Bonding-Schnittstelle mit den zweiten Bonding-Kontakten in Kontakt befinden und wobei die Bonding-Schnittstelle zwischen der ersten Bonding-Schicht und der zweiten Bonding-Schicht das Ergebnis ist von hybridem Bonding, das Metall-Metall-Bonding und Dielektrikum-Dielektrikum-Bonding gleichzeitig erzielt;
wobei die Peripherieschaltung durch die erste Verbindungsschicht elektrisch mit dem Flash-Speicher-Controller verbunden ist; und
wobei die Peripherieschaltung durch die erste und die zweite Verbindungsschicht und die ersten und zweiten Bonding-Kontakte elektrisch mit dem Array von NAND-Speicherzellen verbunden ist,
**dadurch gekennzeichnet, dass**
der Flash-Speicher-Controller und die Peripherieschaltung übereinandergestapelt sind.

2. Speichervorrichtung nach Anspruch 1, wobei die erste Halbleiterstruktur (302) umfasst:
ein Substrat (308);
dem Flash-Speicher-Controller (312) auf dem Substrat;
die Peripherieschaltung (314) auf dem Substrat und außerhalb des Flash-Speicher-Controllers;
und
die erste Bonding-Schicht über dem Flash-Speicher-Controller und der Peripherieschaltung.

3. Speichervorrichtung nach Anspruch 2, wobei die zweite Halbleiterstruktur (304) umfasst:
die zweite Bonding-Schicht (328) über der ersten Bonding-Schicht (324);
einen Speicherstapel (333) über der zweiten Bonding-Schicht;
ein Array von dreidimensionalen 3D, NAND-Speicherstrings (338), die sich vertikal durch Speicherstapel erstrecken; und
eine Halbleiterschicht (348) über und in Kontakt mit dem Array von 3D NAND-Speicherstrings.

4. Speichervorrichtung nach Anspruch 2, wobei die zweite Halbleiterstruktur (304) umfasst:
die zweite Bonding-Schicht (328) über der ersten Bonding-Schicht (324);
ein Array von zweidimensionalen, 2D, NAND-Speicherzellen (337) über der zweiten Bonding-Schicht; und
eine Halbleiterschicht (347) über und in Kontakt mit dem Array von 2D NAND-Speicherzellen.

5. Speichervorrichtung nach Anspruch 4, wobei die zweite Halbleiterstruktur (304) umfasst:
eine Pad-out-Verbindungsschicht (349) über der Halbleiterschicht (347).

6. Speichervorrichtung nach Anspruch 3, wobei die Halbleiterschicht (348)
- Polysilizium
oder
- Einkristallsilizium
umfasst.

7. Speichervorrichtung nach Anspruch 1, wobei die zweite Halbleiterstruktur (304) umfasst:
ein Substrat (348);
einen Speicherstapel (333) über dem Substrat;
ein Array von 3D NAND-Speicherstrings (338), die sich vertikal durch den Speicherstapel erstrecken; und
die zweite Bonding-Schicht (328) über dem Speicherstapel und dem Array von 3D NAND-Speicherstrings.

8. Speichervorrichtung nach Anspruch 1, wobei die zweite Halbleiterstruktur (304) umfasst:
ein Substrat (347);
ein Array von 2D NAND-Speicherzellen (337) auf dem Substrat; und
die zweite Bonding-Schicht (328) über dem Array von 2D NAND-Speicherzellen.

9. Speichervorrichtung nach Anspruch 1, wobei
das ECC-Modul (1008) konfiguriert ist für die Verarbeitung eines ECC; und
das Managementmodul (1004) konfiguriert ist zum Handhaben mindestens eines von Folgendem: Bad-Block-Management, Speicherbereinigung, Umwandlung von logischen in physikalische Adressen oder Wear-Leveling.

10. Verfahren zum Bilden einer Speichervorrichtung (300), umfassend:
Bilden einer ersten Halbleiterstruktur (302) mit einem Flash-Speicher-Controller (312), einer Peripherieschaltung (314) und einer ersten Bonding-Schicht 324) mit einer Mehrzahl von ersten Bonding-Kontakten (326);
Bilden einer zweiten Halbleiterstruktur (304) mit einem Array von NAND-Speicherzellen (337, 416) und einer zweiten Bonding-Schicht (328) mit einer Mehrzahl von zweiten Bonding-Kontakten (330);
wobei die Peripherieschaltung einen oder mehrere Seitenpuffer (204) und Wortleitungstreiber (202) des Array von NAND-Speicherzellen aufweist und wobei der Flash-Speicher-Controller eine Host-Schnittstelle (1002) aufweist, die mit einem Hostprozessor (906) wirkverbunden ist, eine NAND-Speicherschnittstelle (1006), die mit dem Array von NAND-Speicherzellen wirkverbunden ist, ein Managementmodul (1004) und ein Fehlerkorrekturcode(ECC)-Modul (1008);
wobei die erste Halbleiterstruktur eine erste Verbindungsschicht (322) vertikal zwischen der ersten Bonding-Schicht und dem Flash-Speicher-Controller aufweist und die zweite Halbleiterstruktur eine zweite Verbindungsschicht (332) vertikal zwischen der zweiten Bonding-Schicht und dem Array von NAND-Speicherzellen aufweist; und
Bonden der ersten Halbleiterstruktur und der zweiten Halbleiterstruktur Vorderseite an Vorderseite, so dass sich die ersten Bonding-Kontakte an einer Bonding-Schnittstelle (306) mit den zweiten Bonding-Kontakten in Kontakt befinden,
und wobei die Bonding-Schnittstelle zwischen der ersten Bonding-Schicht und der zweiten Bonding-Schicht das Ergebnis ist von hybridem Bonding, das Metall-Metall-Bonding und Dielektrikum-Dielektrikum-Bonding gleichzeitig erzielt;
wobei die Peripherieschaltung durch die erste Verbindungsschicht elektrisch mit dem Flash-Speicher-Controller verbunden ist; und
wobei die Peripherieschaltung durch die erste und die zweite Verbindungsschicht und die ersten und zweiten Bonding-Kontakte elektrisch mit dem Array von NAND-Speicherzellen verbunden ist;
**dadurch gekennzeichnet, dass**
der Flash-Speicher-Controller und die Peripherieschaltung übereinandergestapelt sind.

11. Verfahren nach Anspruch 10, wobei
das Bilden des Flash-Speicher-Controllers (312) und der Peripherieschaltung (314) das Bilden einer Mehrzahl von Transistoren (316) auf einem ersten Substrat (308) der ersten Halbleiterstruktur (302) umfasst.

12. Verfahren nach einem der Ansprüche 10 bis 11, wobei das Bilden der zweiten Halbleiterstruktur (304) umfasst:
Bilden eines Speicherstapels (333) über einem zweiten Substrat (602);
Bilden eines Arrays von dreidimensionalen, 3D, NAND-Speicherstrings (338), die sich vertikal durch den Speicherstapel erstrecken;
Bilden der zweiten Verbindungsschicht (332) über dem Array der 3D NAND-Speicherstrings; und
Bilden der zweiten Verbindungsschicht (328) über der zweiten Verbindungsschicht;
oder
Bilden eines Arrays von zweidimensionalen, 2D, NAND-Speicherzellen (337) auf einem zweiten Substrat (602);
Bilden der zweiten Verbindungsschicht über dem Array von 2D NAND-Speicherzellen;
und
Bilden der zweiten Bonding-Schicht über der zweiten Verbindungsschicht.

13. Verfahren nach einem der Ansprüche 10 bis 12, wobei die zweite Halbleiterstruktur (304) nach dem Bonden über der ersten Haltleiterstruktur (302) liegt, das Verfahren vorzugsweise umfassend:
Verdünnen des zweiten Substrats (602) zum Bilden einer Halbleiterschicht (347, 348) nach dem Bonden; und
Bilden einer Pad-out-Verbindungsschicht (349, 350) über der Halbleiterschicht.

14. Verfahren für den Betrieb der Speichervorrichtung nach einem der Ansprüche 1 bis 9, das Verfahren umfassend:
Empfangen einer Anweisung von einem Hostprozessor (906) durch den Flash-Speicher-Controller (312);
Senden von Steuersignalen durch den Flash-Speicher-Controller an das Array von NAND-Speicherzellen (337, 416) über die Mehrzahl von Bonding-Kontakten (326, 330) zum Steuern von Operationen des Arrays von NAND-Speicherzellen basierend auf den Anweisungen; und
Empfangen von Statussignalen, die die Operationen von dem Array von NAND-Speicherzellen anzeigen, über die Mehrzahl von Bonding-Kontakten durch den Flash-Speicher-Controller, vorzugsweise umfassend:
Übertragen von Daten zwischen der Peripherieschaltung (314) und dem Array von NAND-Speicherzellen über die Mehrzahl von Bonding-Kontakten.

15. Verfahren nach Anspruch 14, ferner umfassend das Speichern von daten in dem Array von NAND-Speicherzellen (337, 416), vorzugsweise umfassend:
Verarbeiten eines Fehlerkorrekturcodes, ECC, bezüglich der Daten durch den Flash-Speicher-Controller (312) und Handhaben mindestens eines von Folgendem: Bad-Block-Management, Speicherbereinigung, Umwandlung von logischen in physikalische Adressen oder Wear-Leveling bezüglich der Daten durch den Flash-Speicher-Controller.

## Revendications

1. Dispositif de mémoire (300) comprenant:
une première structure semi-conductrice (302) comprenant un contrôleur de mémoire flash (312), un circuit périphérique (314) et une première couche de bonding (324) comprenant une pluralité de premiers contacts de bonding (326);
une deuxième structure semi-conductrice (304) comprenant un réseau de cellules de mémoire NAND (337, 416) et une deuxième couche de bonding (328) comprenant une pluralité de deuxièmes contacts de bonding (330);
dans lequel le circuit périphérique comprend un ou plusieurs tampons de page (204) et des pilotes de ligne de mot (202) du réseau de cellules de mémoire NAND, et dans lequel le contrôleur de mémoire flash comprend une interface hôte (1002) connectée de manière fonctionnelle à un processeur hôte (906), une interface de mémoire NAND (1006) connectée de manière fonctionnelle au réseau de cellules de mémoire NAND, un module de gestion (1004) et un module de code de correction d'erreur (ECC) (1008);
la première structure semi-conductrice ayant une première couche d'interconnexion (322) verticale entre la première couche de bonding et le contrôleur de mémoire flash, et la seconde structure semi-conductrice ayant une seconde couche d'interconnexion (332) verticale entre la seconde couche de bonding et le réseau de cellules de mémoire NAND; et
une interface de bonding (306) entre la première couche de bonding et la seconde couche de bonding, dans laquelle les premiers contacts de bonding sont en contact avec les seconds contacts de bonding au niveau de l'interface de bonding, et dans laquelle l'interface de bonding entre la première couche de bonding et la seconde couche de bonding est le résultat d'un bonding hybride qui réalise simultanément un bonding métal-métal et un bonding diélectrique-diélectrique;
le circuit périphérique étant connecté électriquement au contrôleur de mémoire flash par la première couche d'interconnexion; et
le circuit périphérique étant connecté électriquement au réseau de cellules de mémoire NAND par les première et deuxième couches d'interconnexion et les premier et deuxième contacts de bonding,
**caractérisé en ce que**
le contrôleur de mémoire flash et le circuit périphérique sont empilés l'un sur l'autre.

2. Dispositif de mémoire selon la revendication 1, dans lequel la première structure semi-conductrice (302) comprend:
un substrat (308);
le contrôleur de mémoire flash (312) sur le substrat;
le circuit périphérique (314) sur le substrat et à l'extérieur du contrôleur de mémoire flash;
et
la première couche de bonding sur le contrôleur de mémoire flash et le circuit périphérique.

3. Dispositif de mémoire selon la revendication 2, dans lequel la deuxième structure semi-conductrice (304) comprend:
la deuxième couche de bonding (328) au-dessus de la première couche de bonding (324);
un empilement de mémoire (333) au-dessus de la deuxième couche de bonding;
un réseau de chaînes de mémoire NAND tridimensionnelles, 3D, (338) s'étendant verticalement à travers des empilements de mémoire; et
une couche semi-conductrice (348) au-dessus et en contact avec le réseau de chaînes de mémoire NAND 3D.

4. Dispositif de mémoire selon la revendication 2, dans lequel la deuxième structure semi-conductrice (304) comprend:
la deuxième couche de bonding (328) au-dessus de la première couche de bonding (324);
un réseau de cellules de mémoire NAND bidimensionnelles, 2D, (337) au-dessus de la deuxième couche de bonding; et
une couche semi-conductrice (347) au-dessus et en contact avec le réseau de cellules de mémoire NAND 2D.

5. Dispositif de mémoire selon la revendication 4, dans lequel la deuxième structure semi-conductrice (304) comprend: une couche d'interconnexion pad-out (349) au-dessus de la couche semi-conductrice (347).

6. Dispositif de mémoire selon la revendication 3, dans lequel la couche semi-conductrice (348) comprend
- du polysilicium
ou
- du silicium monocristallin.

7. Dispositif de mémoire selon la revendication 1, dans lequel la deuxième structure semi-conductrice (304) comprend:
un substrat (348);
un empilement de mémoire (333) au-dessus du substrat;
un réseau de chaînes de mémoire NAND 3D (338) s'étendant verticalement à travers l'empilement de mémoire; et
la deuxième couche de boding (328) sur l'empilement de mémoire et le réseau de chaînes de mémoire NAND 3D.

8. Dispositif de mémoire selon la revendication 1, dans lequel la deuxième structure semi-conductrice (304) comprend:
un substrat (347);
un réseau de cellules de mémoire NAND 2D (337) sur le substrat; et
la deuxième couche de bonding (328) sur le réseau de cellules de mémoire NAND 2D.

9. Dispositif de mémoire selon la revendication 1, dans lequel
le module ECC (1008) est configuré pour traiter un ECC; et
le module de gestion (1004) est configuré pour gérer au moins une gestion de blocs défectueux, un nettoyage de mémoire, une conversion d'adresses logiques en adresses physiques ou un wear leveling.

10. Procédé de formation d'un dispositif de mémoire (300), comprenant:
former une première structure semi-conductrice (302) comprenant un contrôleur de mémoire flash (312), un circuit périphérique (314) et une première couche de bonding (324) comprenant une pluralité de premiers contacts de bonding (326);
former une deuxième structure semi-conductrice (304) comprenant un réseau de cellules de mémoire NAND (337, 416) et une deuxième couche de bonding (328) ayant une pluralité de deuxièmes contacts de bonding (330);
dans lequel le circuit périphérique comprend un ou plusieurs tampons de page (204) et des pilotes de ligne de mot (202) du réseau de cellules de mémoire NAND, et dans lequel le contrôleur de mémoire flash comprend une interface hôte (1002) connectée de manière fonctionnelle à un processeur hôte (906), une interface de mémoire NAND (1006) connectée de manière fonctionnelle au réseau de cellules de mémoire NAND, un module de gestion (1004) et un module de code de correction d'erreur (ECC) (1008);
dans lequel la première structure semi-conductrice comprend une première couche d'interconnexion (322) verticale entre la première couche de bonding et le contrôleur de mémoire flash, et la seconde structure semi-conductrice comprend une seconde couche d'interconnexion (332) verticale entre la seconde couche de bonding et le réseau de cellules de mémoire NAND; et
bonder la première structure semi-conductrice et la seconde structure semi-conductrice face à face de sorte que les premiers contacts de bonding soient en contact avec les seconds contacts de bonding au niveau d'une interface de bonding (306),
et dans lequel l'interface de bonding entre la première couche de bonding et la deuxième couche de bonding est le résultat d'un bonding hybride qui réalise simultanément un bonding métal-métal et un bonding diélectrique-diélectrique;
le circuit périphérique étant connecté électriquement au contrôleur de mémoire flash par la première couche d'interconnexion; et
le circuit périphérique étant connecté électriquement au réseau de cellules de mémoire NAND par les première et deuxième couches de d'interconnexion et les premier et deuxième contacts de bonding;
**caractérisé en ce que**
le contrôleur de mémoire flash et le circuit périphérique sont empilés l'un sur l'autre.

11. Procédé selon la revendication 10, dans lequel
la formation du contrôleur de mémoire flash (312) et du circuit périphérique (314) comprend la formation d'une pluralité de transistors (316) sur un premier substrat (308) de la première structure semi-conductrice (302).

12. Procédé selon l'une quelconque des revendications 10 à 11, dans lequel la formation de la deuxième structure semi-conductrice (304) comprend:
former un empilement de mémoires (333) sur un deuxième substrat (602);
former un réseau de chaînes de mémoire NAND tridimensionnelles, 3D, (338) s'étendant verticalement à travers l'empilement de mémoire;
former la deuxième couche d'interconnexion (332) sur le réseau de chaînes de mémoire NAND 3D; et
former la deuxième couche de bonding (328) au-dessus de la deuxième couche d'interconnexion;
ou
former un réseau de cellules de mémoire NAND bidimensionnelles, 2D, (337) sur un second substrat (602);
former la deuxième couche d'interconnexion sur le réseau de cellules de mémoire NAND 2D;
et
former la deuxième couche de bonding sur la deuxième couche d'interconnexion.

13. Procédé selon l'une quelconque des revendications 10 à 12, dans lequel la deuxième structure semi-conductrice (304) se trouve au-dessus de la première structure semi-conductrice (302) après le bonding, le procédé comprenant de préférence:
amincir le deuxième substrat (602) pour former une couche semi-conductrice (347, 348) après la bonding; et
former une couche d'interconnexion pad-out (349, 350) sur la couche semi-conductrice.

14. Procédé de fonctionnement du dispositif de mémoire selon l'une quelconque des revendications 1 à 9, le procédé comprenant:
réception d'une instruction d'un processeur hôte (906) par le contrôleur de mémoire flash (312);
l'envoi de signaux de commande par le contrôleur de mémoire flash au réseau de cellules de mémoire NAND (337, 416) par l'intermédiaire de la pluralité de contacts de bonding (326, 330) pour commander des opérations du réseau de cellules de mémoire NAND sur la base des instructions; et
la réception des signaux d'état indiquant les opérations du réseau de cellules de mémoire NAND par l'intermédiaire de la pluralité de contacts de bonding par le contrôleur de mémoire flash, comprenant de préférence:
le transfert des données entre le circuit périphérique (314) et le réseau de cellules de mémoire NAND via la pluralité de contacts de bonding.

15. Procédé selon la revendication 14, comprenant en outre le stockage de données dans le réseau de cellules de mémoire NAND (337, 416), comprenant de préférence:
le traitement d'un code de correction d'erreurs, ECC, concernant les données par le contrôleur de mémoire flash (312) et la gestion d'au moins l'une des opérations suivantes: une gestion de blocs défectueux, un nettoyage de mémoire, une conversion d'adresses logiques en adresses physiques ou un wear leveling concernant les données par le contrôleur de mémoire flash.
